# EUROPEAN PATENT APPLICATION

(11) **EP 2 315 260 A1**
(43) Date of publication of application: **27.04.2011**
(21) Application number: 09794474.8
(22) Date of filing: 08.07.2009
(51) Int. Cl.: H01L 31/04, B32B 9/00, B32B 27/30, B32B 27/36

(54) **SOLAR CELL BACKSHEET**

(30) Priority: 11.07.2008 JP 2008181232
(71) Applicant: Mitsubishi Plastics, Inc., Tokoy 103-0021 (JP)
(72) Inventor: OKAWARA, Chiharu, Ushiku-shi Ibaraki 300-1201 (JP); YOSHIDA, Shigenobu, Ushiku-shi Ibaraki 300-1201 (JP); YAMAZAKI, Yoshihiro, Ushiku-shi Ibaraki 300-1201 (JP)
(74) Representative: Gille Hrabal Struck Neidlein Prop Roos
(86) International application number: PCT/JP2009/062456
(87) International publication number: WO 2010/005030

(57) **Abstract**

Provided is a back sheet for a solar battery which holds an excellent gas barriering property and which is excellent in a weatherability and a light shielding property.

It is a back sheet for a solar battery comprising a light shielding polyolefin base resin colored layer and a weather resistant polyester base resin layer and comprising a gas barriering layer containing a weather resistant coating layer and an inorganic thin film layer provided between the above layers, wherein the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

## Description

### TECHNICAL FIELD

The present invention relates to a back sheet for a solar battery constituting a solar battery module, specifically to a back sheet for a solar battery which holds an excellent gas barriering property and which is excellent in a weatherability and a light shielding property.

### Background Art

In general, a solar battery module has a constitution in which a transparent front substrate, a filler, a solar battery device, a filler and a back sheet are laminated in this order from a light receiving face side. In this connection, the term of a filler includes "a sealing material" which is used as a synonym thereof, but in the present application, hereinafter it shall be described as "a filler" in all cases.
A durability is required to a back sheet for a solar battery in terms of a weatherability, a hydrolytic resistance, a gas barriering property, a mechanical strength, an adhesive property and the like in order to protect a solar battery device when set outdoor for a long time.
On the other hand, while a crystalline silicon base, a polycrystalline silicon base, an amorphous silicon base and the like are used for a solar battery device, solar batteries of a thin film crystal base, an amorphous silicon base, a compound semiconductor base, an organic thin film base, a dye sensitizing base and the like are researched and developed at present as next generation solar batteries, and the various physical properties described above are further highly requested to back sheets thereof. Among them, the weatherability, the hydrolytic resistance and the gas barriering property are listed as particularly important items.

A sheet obtained by laminating a fluorine film and a gas barriering film as a weather resistant film has so far been described as a back sheet for a solar battery in a patent document 1, and the problems that the fluorine film has a low mechanical strength and is expensive and that a supply amount thereof is small have been involved therein.
Further, laminates of a white resin film, a gas barriering film and a hydrolysis resistant film are disclosed in a patent document 2. In the patent document 2, it is described that a surface treated layer may be formed on the substrate film in order to enhance an adhesive property thereof with the gas barriering layer in the gas barriering film. However, this is the same as a publicly known form of a gas barriering film for general packaging and does not allow a back sheet as a constituent material for a solar battery module to be provided with a weatherability and a durability, and it has been completely insufficient for holding a gas barriering property in a high temperature & high humidity test in which a durability of 2000 hours is required under an environment of 85°C and 85 RH %.

On the other hand, it is investigated in a gas barriering film to enhance an adhesive property of an inorganic thin film by subjecting a substrate film to coating treatment in order to inhibit a reduction of a gas barriering property which is brought about by peeling of the inorganic thin film from the substrate film and loss thereof. For example, a coat of a cross-linking reaction product of polyester and isocyanate is disclosed in a patent document 3, but in the coat of the cross-linking reaction product of polyester and isocyanate, an ester group thereof is hydrolyzed under high temperature and high humidity in which a solar battery module is installed, and an adhesive property thereof is notably reduced, which results in a reduction in a gas barriering property. Accordingly, it has not been satisfactory.
Further, an acryl urethane resin is disclosed as an anchor coat layer for a moisture proof film of a back cover material for a solar battery in a patent document 4, but the problem that it is deteriorated as well under high temperature and high humidity as is the case with the polyester and that an adhesive property thereof can not be held has been involved therein.

Patent document 1: Japanese Patent Application Laid-Open No. 174296/2000
Patent document 2: Japanese Patent Application Laid-Open No. 150084/2007
Patent document 3: Japanese Patent Publication 22976/1994
Patent document 4: Japanese Patent Application Laid-Open No. 26343/2002

### Summary of the Invention

### PROBLEMS TO BE SOLVED BY THE INVENTION

In light of the problems described above, the present invention provides a back sheet for a solar battery which holds an excellent gas barriering property and which is excellent in a weatherability and a light shielding property.

### MEANS FOR SOLVING THE PROBLEM

That is, the present invention relates to a back sheet for a solar battery comprising a light shielding polyolefin base resin colored layer (hereinafter referred to as "a light shielding colored layer") and a weather resistant polyester base resin layer and comprising a gas barriering layer containing a weather resistant coating layer and an inorganic thin film layer provided between the above layers, wherein the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

### ADVANTAGES OF THE INVENTION

Effects shown below are provided by the back sheet for a solar battery according to the present invention.
(1) In a solar battery module form in which the back sheet of the present invention is used, a weather resistant polyester layer is provided on an outside face of the back sheet which is an exposed face; a light shielding colored layer comprising a polyolefin base resin is provided on an outside face of the back sheet which is a side brought into contact with a filler; and a gas barriering layer is provided between them, whereby the solar battery can be protected from heat & humidity, a UV ray, moisture and the like;
(2) a gas barriering layer brought into contact with a weather resistant coating layer in the back sheet is provided, whereby large effects are obtained in terms of an adhesive property between an inorganic thin film layer and a base material under heat & humidity and a UV ray, relaxation of stress and inhibition of bleeding out, and as a result thereof, the high gas barriering property can be maintained in a long term weatherability test; and
(3) use of a colored polyolefin resin makes it possible to provide a single layer with both of purposes of a power generation efficiency-improving property, a UV ray resistance, a design property and the like and an adhesive performance with a filler; and further, combining an adhesive layer with a filler and a colored layer into a single layer makes it possible to reduce a lamination number of the back sheet and enhances the production efficiency to a large extent to make it possible to cut the cost.

### MODE FOR CARRYING OUT THE INVENTION

The present invention shall be explained below in detail.

### <Light shielding colored layer>

### Base materials for light shielding colored layer:

A resin constituting the base material for the light shielding colored layer includes usually, for example, polyethylene base resins, polypropylene base resins, cyclic polyolefins base resins, polystyrene base resins, acrylonitrile-styrene copolymers (AS resins), acrylonitrile-butadiene-styrene copolymer (ABS resins), polyvinyl chloride base resins, fluorocarbon base resins, poly (math) acryl base resins, polycarbonate base resins, polyester base resins, polyamide base resins, polyimide base resins, polyamideimide base resins, polyaryl phthalate base resins, silicone base resins, polysulfone base resins, polyphenylene sulfide base resins, polyethersulfone base resins, polyurethane base resins, acetal base resins, cellulose base resins and the like.

Among the resins described above, polyolefin base resins such as polyethylene base resins, polypropylene base resins, cyclic polyolefin base resins and the like can suitably be used. Films comprising a polypropylene base resin and a cyclic polyolefin base resin have the characteristics that they have a high hydrolytic resistance and a high weatherability and are excellent in an aging stability and that they have a non-yellowing property and a good heat melting adhesive property with a filler layer of a solar battery module.

The cyclic polyolefin base resin described above includes, for example, polymers prepared by polymerizing cyclic dienes such as cyclopentadiene and derivatives thereof, dicyclopentadiene and derivatives thereof, cyclohexadiene and derivatives thereof, norbornadiene and derivatives thereof and the like and copolymers prepared by copolymerizing the above cyclic dienes with at least one of olefin base monomers such as ethylene, propylene, 4-methyl-1-pentene, styrene, butadiene, isoprene and the like. Among the above cyclic polyolefin base resins, preferred are the polymers of the cyclic dienes such as cyclopentadiene and the derivatives thereof, dicyclopentadiene and the derivatives thereof or norbornadiene and the derivatives thereof which are excellent in a strength, a heat resistance, a weatherability and the like.

The polyethylene, base resins described above include homopolymers of ethylene, low density polyethylene, linear low density polyethylene, high density polyethylene, ethylene-α-olefin copolymers obtained by copolymerizing them with a metallocene base catalyst and mixtures thereof. Also, homopolymers of propylene, copolymers of propylene, polypropylene base thermoplastic elastomers of a reactor type and mixtures thereof can be shown as the examples of the polypropylene base resins described above.
The copolymers of propylene include random copolymers (random polypropylene) or block copolymers (block polypropylene) of propylene with ethylene or other α-olefins and block copolymers or graft copolymers containing a rubber component. The other α-olefins described above which are copolymerizable with propylene are preferably olefins having 4 to 12 carbon atoms and include, for example, 1-butene, 1-pentene, 1-hexene, 1-heptene, 1-octene, 4-methyl-1-pentene, 1-decene and the like, and one of them or a mixture of two or more kinds thereof is used. Usually, a mixing proportion of α-olefin is 1 to 10 by mass based on propylene.

The polypropylene base thermoplastic elastomers of a reactor type include low crystalline propylene homopolymera having a crystal melting heat (ΔH) of 100 g/J or less ("Idemitsu TPO" manufactured by Idemitsu Petrochemical Co., Ltd., "CAP" manufactured by Ube Industries, Ltd. and "UT2115" manufactured by Ube Rekisen K.K.), polypropylene base thermoplastic elastomers manufactured by a multistage polymerization method ("Catalloy" manufactured by Sun Allomer Ltd., "ZELAS" manufactured by Mitsubishi Chemical Corporation and "Tokuyama PER" manufactured by Tokuyama Corporation) and the like.
The crystal melting heat (ΔH) is a value calculated from a crystal peak area in a DSC chart obtained when a resin is once molten by heating it to a melting point thereof or higher by means of a differential scanning colorimeter and then cooled at a rate of 10°C/minute.
The multistage polymerization method described above means a polymerization method in which polymerization is not finished in one stage and in which plural kinds of polymers can continuously be produced by carrying out multistage polymerization of two or more stages, and it is a method different from a so-called conventional polymer blend method in which a mixed resin comprising different kinds of polymers is obtained by using mechanical means. The above method makes it possible to form a copolymer resin of a blend type on a molecular level. Employing the above method makes it possible, for example, to add a second component of up to about 80 to 95 % by mass based on polypropylene.

The polypropylene base thermoplastic elastomers obtained by the multistage polymerization method are copolymers obtained by polymerizing (i) a hard segment and (ii) a soft segment in a multistage of two or more stages in a reactor. The hard segment (i) includes propylene homopolymer blocks and copolymer blocks of propylene and α-olefins, for example, binary or ternary copolymer blocks such as propylene/ethylene, propylene/1-butene, propylene/ethylene/1-butene and the like. The soft segment (ii) includes ethylene homopolymer blocks and copolymer blocks of ethylene and α-olefins, for example, binary or ternary copolymer blocks such as ethylene/propylene, ethylene/1-butene, ethylene/propylene/1-butene and the like.
In the present invention, among the polypropylene base thermoplastic elastomers produced by the multistage polymerization method, the elastomers in which a melt flow rate is 0.1 to 30 and in which a proportion of a matter soluble in xylene at 23°C is 30 to 75 % by mass, preferably 40 to 60 % by mass are particularly preferred in terms of a compatibility and a viscoelasticity.

When a polypropylene base resin is used as the polyolefin base resin of the light shielding colored layer, a content of the polypropylene base resin is preferably 40 to 100 % by mass, particularly preferably 50 to 100 % by mass in terms of having in combination an adhesive property with a filler, a heat resistance and a rigidity required for handling in laminating in order to mold the back sheet. Further, among the polypropylene base resins, the resins in which a composition ratio of a propylene homopolymer is 5 to 80 %, preferably 10 to 60 % are preferred in terms of an adhesive property, a heat resistance, a rigidity and a non-curling property.
Further, other synthetic resins can be mixed with the resin of the light shielding colored layer. The other synthetic resins mixed include, for example, diene base rubbers (elastomers) such as isoprene rubber, butadiene rubber, butyl rubber, propylene-butadiene rubber, acrylonitrile-butadiene rubber, acrylonitrils-isoprene rubber and the like, polyolefin base thermoplastic elastomers other than the polypropylene base thermoplastic elastomers of a reactor type described above, such as ethylene-propylene copolymer rubbers, ethylene-propylene non-conjugate diene rubbers, ethylene -butadiene copolymer rubbers and the like, styrene- butadiene base thermoplastic elastomers such as styrene-butadiene copolymer rubbers (SBR), styrene-butadiene block copolymers and the like and styrene base thermoplastic elastomers (including hydrogenated products thereof) such as styrene-isoprene copolymer rubbers and the like.
The other synthetic resins such as the above elastomer components and the like can be blended in an amount of 0 to 60 parts by mass based on 100 to 40 parts by mass of the olefin base resin in the light shielding colored layer.

### Coloring of light shielding colored layer:

The light shielding colored layer is used as a constitutional material at a side brought into contact with a filler at a rear face side of the back sheet for a solar battery for the purpose of reflecting a sunlight transmitted through the solar battery cell to enhance the power generation efficiency and the purpose of reflecting or absorbing a UV ray to thereby prevent a material constituting the above back sheet for a solar battery from being deteriorated by a UV ray and improve Various characteristics of the back sheet, such as a weatherability, a durability, a heat resistance, a thermal dimensional stability, a strength and the like. In particular, whitening is effective in terms of reflecting a sunlight to improve the power generation efficiency.
Further, a design property and a decorative property of the solar battery module can be improved by various colorings including blackening.
In the present invention, "a light reflection property" is included in a light shielding property in "the light shielding colored layer", and light scattering in addition to light reflection is included as well in a light reflection property.
In this connection, "a light reflectiveness" in a case where the light shielding colored layer has a light reflectiveness means that a light transmission factor in a wavelength of 350 nm is 1.0 % or lees, and it is preferably 0.8 % or less, more preferably 0.5 % or less in terms of a weatherability. Also, when the light shielding colored layer is a white layer, a whiteness degree thereof is measured by a Hunter method according to JIS L1015, and a value thereof is preferably 75 % or more, more preferably 80 % or more in terms of enhancing a power generation coefficient of the solar battery.

Among the above methods, coloring by adding a pigment has a high power of inhibiting transmission of a UV ray and therefore is preferred as a method for coloring the light shielding colored layer in terms of preventing UV ray deterioration of a gas barriering layer and a weather resistant layer which are located at a lower side of the colored layer observing from a sunlight receiving side.
The pigment used for coloring the base material includes preferably white pigments, black pigments and the like. The white pigments shall not specifically be restricted, and capable of being used are, for example, calcium carbonate, anatase type titanium oxide, rutile type titanium oxide, zinc oxide, lead carbonate, barium sulfate, basic lead carbonate, basic lead sulfate, basic lead silicate, zinc oxide, zinc sulfide, lithopone, antimony trioxide and the like. Titanium oxide of a rutile type is preferred since it is less yellowed than titanium oxide of an anatase type after the polyester film is irradiated with a light for a long time and is suited to inhibiting a change in the color difference.
Among the white pigments described above, at least one kind of inorganic fine particles selected from the group consisting of rutile type titanium oxide, barium sulfate, calcium carbonate and silicon dioxide is preferred in terms of a stability and a non-heavy metal compound.
The black pigment used as the colorant includes, for example, carbon black, black iron oxide and the like, and the coloring agent includes, for example, organic dyes of an azo base, an anthraquinone base, a phthalocyanine base, a thioindigo base, a quinacridone base, a dioxazine base and the like, pigments, inorganic pigments such as ultramarine, Prussian blue, chrome vermilion, red iron oxide, cadmium red, molybdenum orange and the like and metal powder pigments for metallic gloss. Carbon black and the inorganic pigments are preferred in terms of a long term color stability.
The colorants used in the present invention may be used alone or in combination of two or more kinds thereof.

An average particle diameter of the pigments which are the colorants described above is preferably 5 nm or more and 30 µm or less, more preferably 10 nm or more and 3 µm or less and further preferably 50 nm or more and 1 µm or less. If an average particle diameter of the pigments falls in the ranges described above, a dispersibility thereof into the resin is prevented from being deteriorated by aggregation, and coarse projections are prevented from being produced on the light shielding colored layer. Further, a coloring degree thereof is readily controlled.
An addition amount of the colorant in the light shielding colored layer described above shall not specifically be restricted as long as it falls in a range in which the light shielding colored layer can be provided with a light reflectiveness, a UV ray resistant property and a design property in terms of a desired light shielding property, and usually it falls in a range of preferably 1 to 40 % by mass, more preferably 5 to 30 % by mass and further preferably 10 to 20 % by mass in the light shielding colored layer. If the above addition amount falls in the ranges described above, the film is excellent in a durability, a heat resistance and a strength, and a dispersibility of the pigment in the resin layer is good.

Various methods can be used as a method for adding the pigment to the colored layer, and it includes, to be specific, (a) a method in which the pigment is added in synthesizing the resin, (b) a method in which the pigment is added to the resin and in which the mixture is molten and kneaded, (c) a method in which the pigment is added in a large amount in the method (a) or the method (b) to prepare a master pellet and in which the master pellet is kneaded with the resin containing no additives to control a concentration thereof to a desired level, (d) a method in which the master pellet prepared in the method (c) described above is used as it is and the like. Among them, the master batch method of (c) is preferred in terms of a concentration controlling property.

### Formation and properties of the light shielding colored layer:

The light shielding colored layer described above may be formed in a single layer, and it is preferably a multilayer of two or more layers. Further, it has preferably a three layer structure comprising an inner layer and outer layers at both sides thereof or a five layer constitution comprising an inner layer, an intermediate layer and outer layers. It can have a seven layer constitution comprising an inner layer 1, an inner layer 2, an outer layer 1 and an outer layer 2. In a case of the multilayer, the respective layers each may be colored, and a case in which an inner layer is colored and in which outer layers are transparent is preferred. To be specific, it is a constitution in which
transparent polyolefin base resin layers are provided at least on outside surfaces of a colored layer containing a pigment, and it is a constitution in which a colored layer containing a pigment is provided as an inner layer and in which transparent polyolefin base resin layers are provided as outer layers at both sides thereof.
In the above constitution, the light shielding colored layer is formed in a multilayer, and the colored layers are aggregated to an inner layer, whereby a use amount of the colorant can be reduced to provide a high light reflectiveness and a high UV ray reflectiveness, and the appearance and the color phase can be maintained well without allowing the colorant to be exposed in forming a solar battery module by vacuum lamination molding or in an environment of high temperature and a high humidity.
Further, transparentizing an outer layer at a side brought into contact with a filler of a solar battery module and adding no colorant thereto do not weaken a bonding force between resins in the outer layer and make it possible to strengthen an adhesive force of the solar battery module with the filler and an interlayer laminated adhesive strength of the solar battery back sheet and maintain more an adhesive property even under high temperature and high humidity.

When the light shielding colored layer is a film, a case in which a multilayer constitution is a layer constitution symmetrical to an inner layer is desirable in terms of a non-curling property and a coextruded film productivity. In a case of the multilayer, a tensile modulus of an outer layer is preferably not smaller than those of layers extruding the outer layer in terms of relaxing a stress between a filler and constituent parts of a gas barriering layer and a weather resistant layer in the back sheet to maintain an adhesive property and in terms of a film handling property.
The specific example of the above symmetric layer constitution includes a transparent polyolefin resin layer/polyolefin resin layer containing a pigment selected from titanium oxide, barium sulfate and carbon black/transparent polyolefin resin layer.
Also, when an intermediate layer is provided between an inner layer and an outer layer, it is significant for maintaining a balance of a strength and an elasticity of the whole polyolefin resin layer to add a resin enhancing an adhesive property with the inner layer and the outer layer to the intermediate layer, change a composition of the intermediate layer to a composition containing the respective components of the inner layer and the outer layer to enhance an affinity of the layer interfaces and reduce a difference in the mechanical properties between the inner layer and the outer layer.

When the light shielding colored layer has a multilayer constitutions, a thickness ratio of the respective layers shall not be restricted, and a thickness of a transparent outer layer at a filler side accounts for preferably 5 to 80 %, more preferably 10 to 50 % based on a whole thickness of the light shielding colored layer. If a thickness of the transparent outer layer is too small, an adhesive force with the filler and a merit of aggregating the colorant to the sinner layer are low, on the contrary, if a thickness of the transparent outer layer is too large, an excess amount of the colorant is added to the inner layer in order to provide the thin inner layer with a sufficiently high coloring degree, and therefore the layer is reduced in a mechanical strength.
The light shielding colored layer can be formed either by a melt extrusion method or a method of dry-laminating a film. In a case of the dry-laminating method, the adhesive of the back sheet can be applied as well.
The polyolefin film can be prepared by a publicly known method, and it includes, for example, an extrusion molding method such as a T die molding method and the like, an inflation molding method, a calendar molding method and the like. Then, the film may be subjected, if necessary, to monoaxial stretching- and simultaneous or sequential biaxial stretching by a tenter method, a tubular method and the like.
In a case of the multilayer film, a method in which the respective molded layers are subjected to dry lamination and a method in which the films are subjected to pressure bonding lamination at the same time as molding can be used as a method for laminating the respective layers, and a method in which a laminated film is prepared by a multilayer T die extrusion method at the same time as molding is preferred in terms of reducing the step number.
A tensile modulus of the light shielding colored layer is preferably 200 to 2000 MPa, more preferably 300 to 1500 MPa and particularly preferably 500 to 1200 MPa, If the tensile modulus is too small, the film is liable to be elongated, and defects are liable to be brought about in terms of a tensile force balance in a lamination step of the back sheet, a curling property and a blocking property. On the contrary, if it is too large, a difference in a stress between the sealing material and the back Sheet is insufficiently relaxed to bring about a reduction in the adhesive property.
Further, a surface of the light shielding colored layer is preferably subjected to surface modifying treatment such as corona discharge treatment, ozone treatment, plasma treatment and the like in order to enhance an adhesive property with the filler.
The light shielding colored layer of the present invention has a good adhesive property with an ethylene-vinyl acetate copolymer (EVA) which is used in many cases as a filler constituting a solar battery module, and it is not necessary to further provide a readily-adhesive layer.

The light shielding colored layer can be blended with various additives and the like for the purpose of improving and modifying a processability, a heat resistance, a weatherability, mechanical properties, a dimensional stability and the like in a range in which an adhesive property with the filler is maintained under high temperature and high humidity. The above additives include, for example, lubricant, blocking resistant agents, cross-linking agents, antioxidants, UV ray absorbers, light stabilizers, fillers, reinforced fibers, reinforcing materials, antistatic agents, fire retardants, flame retardants, foaming agents, fungicides and the like. In particular, a UV ray absorber, a light stabilizer and an antioxidant are preferably added from a viewpoint of the weatherability.
The UV ray absorber includes, for example, UV ray absorbers of a salicylic acid ester base, a benzophenone base, a benzotriazole base, a cyanoacrylate base, a triazine base and the like. Among them, the UV ray absorbers of a benzotriazole base, a cyanoacrylate base or a triazine base which have a molecular weight of 300 or more are preferred from the viewpoint that bleed-out is less liable to be brought out under environmental aging.
The light stabilizer is preferably hindered amine base stabilizers in terms of a light stabilizing performance. Among them, the stabilizers having a molecular weight of 1000 or more are preferred from the viewpoints that bleed-out is less liable to be brought out under environmental aging and that a long term weatherability is good. In particular, the stabilizers obtained by copolymerizing polyolefins with compounds having a hindered amine skeleton are preferred.
The antioxidant includes phenol base, sulfide base, phosphorus base and isocyanurate base antioxidants. Among them, the phenol base antioxidants are preferred in terms of an antioxidant effect. Further, combined use of the phenol base antioxidants and the phosphorus base antioxidants is preferred since the heat stability is improved.

A thickness of the light shielding colored layer can suitably be selected according to uses of the back sheet for a solar battery and the specifications of the solar battery cell and the module, and the thickness is 10 to 200 µm, preferably 30 to 150 µm and more preferably 50 to 120 µm in terms of obtaining the satisfactory chromaticity and the satisfactory reflection intensity as the sunlight reflection performances of the above light shielding colored layer. If the thickness is small, a stress of the filler and the sealing material with the back sheet is insufficiently relaxed in a peeling test, and the layer tends to be liable to be peeled. When the thickness is large, the back sheet tends to be insufficient in a rigidity or increased in curling.
In terms of the above matters, a thickness ratio of the light shielding colored layer to parts constituting the back sheet excluding the light shielding colored layer is desirably 10 to 100 %, preferably 15 to 75 % and more preferably 20 to 50 %. Or, a tensile modulus ratio (a) and a thickness ratio (b) of the light shielding colored layer to the parts constituting the back sheet excluding the light shielding colored layer resides in a relation of (a)/(b) = 0.1 to 10 times, preferably 0.5 to 8 times and more preferably 1 to 5 times.
Also, a thickness unevenness of the whole light shielding colored layer is desirably within ± 10 % in terms of a moldability in vacuum lamination in which the solar battery module is prepared. Further, a thermal shrinkage rate of the light shielding colored layer is preferably 2 % or less, more preferably 1 % or less, 0.2 to 0.5 %, 0.005 to 0.5 % in heating at 150°C for 30 minutes (JIS C2151) in terms of preventing the productivity from being reduced in a heating pressure bonding step in producing the solar battery module.

### <Weather resistant polyester base resin layer>

### Polyester base resin:

A polyester base resin which is excellent in a hydrolytic resistance and a heat resistance is used for the weather resistant polyester base resin layer.
Polyethylene terephthalate, polyethylene naphthalate and polyethylene 2,6-phthalenedicarboxylate are preferably used as the polyester resin in terms of the industrial productivity, and polyethylene terephthalate and polyethylene naphthalate are more preferably used.
A film comprising polyethylene terephthalate is excellent in terms of a transparency, a productivity and a versatility, and a film comprising polyethylene naphthalate is excellent in terms of a high hydrolytic resistance, a heat resistance, a toughness, a low oligomer property and a low water vapor transmission rate.

Polyethylene naphthalate is a polyester resin comprising ethylene naphthalate as a principal repetitive unit, and it is synthesized by using naphthalenedicarboxylic acid as principal dicarboxylic acid and ethylene glycol as a principal glycol component.
From the viewpoint that polyethylene naphthalate used for the above weather resistant polyester base resin layer is excellent in a hydrolytic resistance, a strength and a barriering property, the ethylene naphthalate unit accounts preferably for 80 mole % or more of a whole repetitive unit of the polyester.
The naphthalenedicarboxylic acid described above includes 2,6-naphthalenedicarboxylic acid, 1,4-naphthalenedicarboxylic acid, 1,5-naphthalenedicarboxylic acid, 1,3-naphthalenedicarboxylic acid and the like, and among them, 2,6-naphthalenedicarboxylic acid is preferred in terms of the hydrolytic resistance and the like.

The above polyethylene naphthalate resin contains preferably aromatic polyester. Containing aromatic polyester in polyethylene terephthalate makes it possible to enhance a nodal strength, a peeling resistance, a mechanical strength and the like of the above polyethylene naphthalate film while maintaining a hydrolytic resistance thereof. A content of the above aromatic polyester is preferably 1 to 10 % by mass in the polyethylene naphthalate film. The nodal strength, the peeling resistance, the mechanical strength and the like can affectively be enhanced by controlling a content of the aromatic polyester to the range described above. The above aromatic polyester is, to be specific, preferably polyester obtained by copolymerizing a terephthalic acid component and 4,4'-diphenyldicarboxylic acid as principal dicarboxylic acid components with ethylene glycol as a principal glycol component.

A production process for the above polyester base resin includes, for example, a process in which it is produced by a first stage reaction of esterifying directly an acid component and a diol component or subjecting dialkyl ester used as the acid component to transesterification reaction with the diol component and then a second stage reaction of melting and polymerizing the product of the above reaction while heating it under reduced pressure to remove the surplus diol component and a process in which it is produced by a third stage reaction of further subjecting the product of the second stage reaction to solid phase polymerization. The solid phase polymerization is preferably used for obtaining the polyester base resin having a small amount of a carboxy end group.
Also, the above polyester base resin may contain a polyether compound in order to adjust a viscosity of the polyester base resin. The above polyether compound shall not specifically be restricted, and for example, polyether compounds comprising polyethylene oxide or diol as a principal constitutional component can be used.

The polyether compound preferably used in the present embodiment includes, for example, polyether compounds comprising at least one of polyethylene oxide, polyethylene glycol, polypropylene glycol, polytetramethylene glycol and copolymers of the above polyether compounds.
Polyether compounds in which ends are blocked may be used as the polyether compound described above. The above polyether compounds in which ends are blocked have the advantage that they can inhibit the polyester base resin from being hydrolyzed. The polyether compounds in which ends are blocked includes, for example, polyether compounds in which a hydroxyl group at an end of polyether is subjected to alkyl etherification, that is, ends are blocked by a methoxy group, an ethoxy group and the like.

An average molecular weight of the polyether compound described above shall not specifically be restricted, and it is preferably 500 to 10,000, more preferably 700 to 5,000 in terms of a number average molecular weight from the viewpoint of a compatibility with the polyester base resin.
A content of the polyether compound used in the present embodiment shall not specifically be restricted, and usually it falls in a range of preferably 0.1 to 10 % by mass, more preferably 0.2 to 7 % by mass and particularly preferably 0.2 to 5 % by mass in the polyester base resin.

### Weather resistant polyester base resin layer:

A guarantee period of a solar battery module is prolonged from 10 years to 20 years, 30 years, and a back sheet for a solar battery have to be improved in a weatherability and a durability in order to satisfy the above situation. In this regard, a strength holding rate of the weather resistant polyester base resin layer in the above back sheet for a solar battery after 3000 hours at a temperature of 85°C and a relative humidity of 85 % is preferably 50 % or more, more preferably 60 % or more.
The strength holding rate is shown by a ratio (%) of a rapture strength of the sample after an environmental test at a temperature of 85°C and a relative humidity of 85 % for 3000 hours to that of the sample before the environmental test, wherein the sample is cut from the weather resistant polyester base resin layer in a width of 15 mm, and the tensile rapture strengths thereof before and after the environmental test are measured respectively by means of a tensile test equipment.

A molecular weight, an end carboxyl group amount, an oligomer amount and the like of the principal raw material resin participate in a durability of the above weather resistant polyester base resin layer to a large extent, and an effect of adding a hydrolysis resistant agent, an antioxidant and the like exerts strong influences thereon.
A molecular weight of the polyester base resin falls in a range of preferably 18,000 to 42,000, more preferably 19,000 to 40,000 in terms of a number average molecular weight from the viewpoint of a weatherability, particularly a hydrolytic resistance.
The number average molecular weight can be measured on the following conditions by a resin GPC (gel permeation chromatography) method.
(a) Apparatus: gel permeation chromatograph GCP-244 (manufactured by Waters Corporation)
(b) Column: Shodex HFIP 80M two columns (manufactured by Showa Denko K.K.)
(c) Solvents: hexafluoropropanol (0.005N sodium trifluoroacetate)
(d) Flow rate: 0.5 ml/minute
(e) Temperature: 23°C
(f) sample concentration: 0.06 % (completely dissolved, filtrated: MyShoriDisk W-13-5)
(g) Injection amount: 0.300 ml
(h) Detector: R-401 differential refractometer (manufactured by Waters Corporation)
(i) Molecular weight calibration: PET-DMT (standard product)
An amount of an end carboxyl group in the polyester base resin is preferably 5 to 40 eq/ton, more preferably 5 to 15 eq/ton in terms of a hydrolytic property of the polyester base resin under high temperature and high humidity environment and a durability, a productivity and the like of the back sheet for a solar battery.
An amount of the oligomer which is a low polymer having a repetitive number (polymerization degree) of about 2 to 20 in the polyester base resin is preferably 0.1 to 0.8 % by mass, more preferably 0.5 % by mass or less and further preferably 0.3 % by mass or less in terms of a hydrolytic property thereof. In general, the polyethylene naphthalate resin has preferably the characteristic that an oligomer amount is small.
A content of the oligomer can be analyzed by mass % of the oligomer based on the polyester base resin, wherein 100 mg of the polyester base resin is dissolved in, for example, 2 mL of any solvent of phenol/1,2-dichlorobenzene (mass ratio: 50/50), phenol/1,1,2,2-tetrachloroethane (mass ratio: 50/50), o-chlorophenol and dichloroacetic acid, and the solution is measured by means of a liquid chromatography.
The weather resistant polyester base resin layer contains preferably a carbodiimide compound. End carboxyl groups in the polyester base resin and carboxyl groups produced by hydrolysis are reacted with the carbodiimide compound by adding the carbodiimide compound, and the hydrolytic resistance is enhanced. A content of the above carbodiimide compound is preferably 0.1 to 10 % by mass, more preferably 0.5 to 3 % by mass.

The carbodiimide compound described above includes, for example, monocarbodiimides such as N',N'-diphenylcarbodiimide, N,N'-diisopropylphenylcarbodiimide, N,N'-dicyclohexylcarbodiimide, 1,3-diisopropylcarbodiimide, 1- (3-dimethylaminopropyl)-3-ethylcarbodiimide and the like and polycarbodiimides such as poly(1,3,5-triisopropylphenylene-2,4-carbodiimide) and the like. Among them, N,N'-diphenylcarbodiimide and N,N'-diisopropylphenylcarbodiimide can preferably be used in terms of a versatility molecular weight of the carbodiimide compound falls in a range of generally 200 to 1000, particularly preferably 200 to 600 in terms of a dispersibility and a scattering property of the compound.
Further, an antioxidant in addition to the carbodiimide compound described above is preferably added to the polyester base resin layer. Adding both of the carbodiimide compound and the antioxidant makes it possible to enhance further the hydrolytic resistance described above and inhibit the carbodiimide compound from being recomposed. The antioxidant described above includes, to be specific, hindered phenol base compounds and thioether base compounds, and the hindered phenol base compounds are preferred in terms of an oxidation inhibitory property.
A content of the above antioxidant is preferably 0.05 to 1 % by mass, more preferably 0.1 to 0.5 % by mass in terms of an enhancing effect of a decomposition inhibitory performance and a hydrolytic resistance of the carbodiimide compound and maintaining a color tone of the resin layer. A mass ratio of a content of the antioxidant to a content of the carbodiimide compound is preferably 0.1 to 1.0, more preferably 0.15 to 0.8 in terms of a sufficiently high effect of inhibiting the hydrolysis. A method for adding the carbodiimide compound and the antioxidant may be either a method in which they are kneaded with the polyester base resin or a method in which they are added in a polycondensation reaction of the resin.
A thickness of the weather resistant polyester base resin layer is preferably 10 to 500 µm, more preferably 25 to 200 µm in terms of a weatherability and a durability. If the thickness is too small, the strength after the test at a temperature of 85°C and a relative humidity of 85 % is reduced to a large extent, and if it is too large, the cast grows higher.

### Formation of the weather resistant polyester base resin layer:

The above weather resistant polyester base resin layer can be produced by a publicly known method. In a case of, for example, producing it in a form of a polyester base resin film, the raw material resin is molten by an extruding equipment and extruded from a circular die or a T die, and the film is rapidly cooled, whereby the non-stretched film which is substantially amorphous and is not oriented can be produced. Further, a single layer film comprising one kind of a resin, a multilayer film comprising one kind of a resin and a multilayer film comprising various kinds of resins can be produced by using a multilayer die.
A film which is stretched at least in a monoaxial direction can be produced by stretching the above non-stretched film in a flowing (vertical axis) direction of the film or in a flowing direction of the film and a direction perpendicular (lateral axis) thereto by a publicly known method such as monoaxial stretching, tenter type sequential biaxial stretching, tenter type simultaneous biaxial stretching, tubular type simultaneous biaxial stretching and the like and thermally fixing it. The stretching magnification and the thermally fixing temperature can optionally be set, and the thermal shrinkage rate at 150°C for 30 minutes resides in a condition of satisfying preferably 1.0 % or less, more preferably 0.1 to 0.5 % and further preferably 0.005 to 0.5 %.
The polyester base resin film is preferably a biaxially stretched polyethylene terephthalate film, a biaxially stretched polyethylene naphthalate film and a coextruded biaxially stretched film of polyethylene terephthalate and/or polyethylene naphthalate with other plastics in terms of the physical properties of the film.

### <Gas barriering layer>

### Base material of gas barriering layer:

A base material for the gas barriering layer is preferably a thermoplastic high polymer, and it can be used without any specific restrictions as long as it is a resin which can be used for usual packaging materials. To be specific, it includes polyolefins such as homopolymers or copolymers of ethylene, propylene, butene and the like, amorphous polyolefins such as cyclic polyolefins and the like, polyesters such as polyethylene terephthalate, polyethylene 2,6-naphthalate and the like, polyamides such as nylon 6, nylon66, nylon 12, copolymer nylon and the like, ethylene-vinyl acetate copolymer-partially hydrolyzed products (EVOH), polyimides, polyetherimides, polysulfones, polyethersulfones, polyetheretherketones, polycarbonates, polyvinylbutyrals, polyallylates, fluorocarbon resins, acrylate resins and the like. Among them, polyesters, polyamides and polyolefins are preferred in terms of the physical properties of the film. Above all, polyethylene terephthalate and polyethylene naphthalate are more preferred in terms of a strength of the film. Further, polyethylene naphthalate is preferred in terms of a weatherability and a hydrolytic resistance of the film.
The base material for the light shielding colored layer or the base material for the weather resistant polyester base resin layer each described above can be used as the base material for the gas barriering layer, and this makes it possible to provide the gas barriering layer with a light shielding coloring function and a gas barriering function or a gas barriering function and a weather resistant function in combination.
Further, capable of being added to the base material described above are, for example, publicly known additives such as antioxidant, light shielding agents, UV absorbers, hydrolytic resistance-improving agents, plasticizers, sliding agents, fillers, colorants, stabilizing agents, lubricants, cross-linking agents, blocking inhibitors, antioxidants and the like. In particular, 0.1 to 10 % by mass of carbodiimide is preferably added as the hydrolytic resistance -improving agent in terms of enhancing a weatherability of the films.

The base material described above is preferably used in a form of a base material film. A thermoplastic high polymer film as the base material film is molded by using the raw materials described above, and when it is used as the base material film, it may be non-stretched or stretched. Further it may be laminated with other plastic base materials.
The above base material film can be produced by a publicly known method. For example, the raw material resin is molten by an extruding equipment and extruded from a circular die or a T die, and the film is rapidly cooled, whereby the non-stretched film which is substantially amorphous and is not oriented can be produced. Further, a single layer film comprising one kind of a resin, a multilayer film comprising one kind of a resin and a multilayer film comprising various kinds of resins can be produced by using a multilayer die.
A film which is stretched at least in a monoaxial direction can be produced by stretching the above non-stretched film in a flowing (vertical axis) direction of the film or in a flowing direction of the film and a direction perpendicular (lateral axis) thereto by a publicly known method such as mono axial stretching, tenter type sequential biaxial stretching, tenter type simultaneous biaxial stretching, tubular type simultaneous biaxial stretching and the like. The stretching magnification can optionally be set, and a thermal shrinkage rate of the film at 150°C for 30 minutes is preferably 0.01 to 3 %, more preferably 0.01 to 1 % and further preferably 0.005 to 0.5 %.
Among them, a biaxially stretched polyethylene terephthalate film, a biaxially stretched polyethylene naphthalate film and a coextruded biaxially stretched film of polyethylene terephthalate and/or polyethylene naphthalate with other plastics are preferred in terms of the physical properties of the film. Further, a biaxially stretched film containing polyethylene naphthalate such as a biaxially stretched polyethylene naphthalate film and a coextruded biaxially stretched film of polyethylene naphthalate with plastics such as polyethylene terephthalate and the like is preferred in terms of a weatherability and a hydrolytic resistance.

A thickness of the base material film is selected in a range of usually 5 to 500 µm, preferably 10 to 200 µm according to the uses thereof in terms of a mechanical strength, a flexibility and the like of the back sheet for a solar battery according to the present invention, and a sheet-like base material having a large thickness is included therein,
Further, in order to improved a coating property and an adhesive property of a weather resistant coating agent for forming the weather resistant coating layer onto the base material film, the film may be subjected to conventional surface treatment such as chemical treatment, discharge treatment and the like before coating the weather resistant coating agent.

### Weather resistant coating layer:

The gas barriering layer has to have a long term weatherability and maintain a gas barriering property in terms of using it in the back sheet for a solar battery. Accordingly, in the present invention, the weather resistant coating layer is formed in order to provide the base material film with a bleed-out, inhibitory property and an adhesive property with an inorganic thin film from the viewpoint of a long term weatherability of the gas barriering layer.
In the present invention, the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

### (a) Cross-linked product of polycaprolactonepolyol and/or polycarbonatepolyol:

Polyesterpolyol and polyetherpolyol have so far been used as an anchor coating agent in many cases, and polyesterpolyol is liable to be hydrolyzed. Polycaprolactonepolyol is excellent in a moisture resistance as compared with adipate polyesterpolyol, and it is excellent in a weatherability and a heat resistance as compared with polyetherpolyol. Further, polycarbonatepolyol is excellent in a heat resistance, a moisture resistance and a weatherability as compared with polyesterpolyol and polyetherpolyol. From the viewpoints described above, the cross-linked product of polycaprolactonepolyol and/or polycarbonatepolyol is used as the weather resistant coating agent in the present invention.
Polycaprolactonepolyol and polycarbonatepolyol can improve the interlayer adhesive property more as compared with polyesterpolyol by means such as controlling a degree of surface treatment including corona treatment and the like in the base material film, coating very thinly in advance only an adhesive component such as a cross-linking agent and the like or a silane coupling agent and a titanium base coupling agent and increasing a blend ratio of a cross-linking compound in a coating material, and this makes it possible to improve more a weatherability of the coated layer.

### Polycaprolactonepolyol:

Polycaprolactonepolyol is produced by subjecting ε-caprolactone to ring-opening polymerization using polyhydric alcohol shown below as an initiator under the presence of a catalyst according to a publicly known method.
Polyhydric alcohol which is an initiator for ε-caprolactone includes ethylene glycol, diethylene glycol, 1,2-propylene glycol, dipropylene glycol, 1,3-butanediol, 1,4-butanediol, 1,6-hexanediol, neopentyl glycol, trimethylolpropane, glycerin, pentaerythritol and polytetramethylene ether glycol. Further, capable of being used as well are aliphatic polyhydric alcohols such as polymerization products or copolymerization products which are obtained by subjecting ethylene oxide, propylene oxide and butylene oxide to ring-opening polymerization using the above polyhydric alcohols as an initiator; polyhydric alcohols containing a cyclohexyl group such as cyclohexanedimethanol, cyclohexanediol, hydrogenated bisphenol A and polymerization products or copolymerization products which are obtained by subjecting ethylene oxide, propylene oxide and butylene oxide to ring-opening polymerization using the above glycols as an initiator; polyhydric alcohols containing an aromatic group such as bisphenol A, hydroquinonebis(2-hydroxyethyl ether), p-xylene glycol, bis(β-hydroxyethyl) terephthalate and polymerization products or copolymerization products which are obtained by adding ethylene oxide, propylene oxide and butylene oxide using the above glycols as an initiator; and polyhydric alcohols having various functional groups including glycols having carboxyl groups such as dimethylolpropionic acid, diphenolic acid and the like and glycols having tertiary amines such as N-methyldiethanolamine and the like.

### Polycarbonatepolyol:

Polycarbonatepolyol can be prepared by a publicly known method.
Preferably used as polycarbonatediol are polycarbonatediols obtained by reacting diphenyl carbonate or phosgene with aliphatic diols having 2 to 12 carbon atoms, such as 1,4-butanediol, 1,5-pentanediol, 1,6-hexanediol, 1,8-octanediol, 1,10-decanediol and the like or mixtures thereof to subject them to polycondensation.
Ether-modified polycarbonatepolyols having a repetitive structural unit of -[(CH₂)₃-OC(O)O]- or -[(CH₂)₂C(CH₃) (CH₃)₂-OC(O)O]-, which are obtained by reacting polyalkylenecarbonatepolyols having a number average molecular weight of 10,000 or less, preferably 500 to 5,000 with polyethylene glycol monoalkyl ethers having a number average molecular weight of 5,000 or less are preferred in terms of a compatibility with an organic solvent and a cross-linking agent. Incidentally, the number average molecular weight is a polystyrene-reduced value obtained by the gel permeation chromatographic analysis described above.
Polycarbonatepolyol has an end hydroxyl group index of preferably 92.5 to 98.5, more preferably 95.0 to 97.5 in terms of carrying out homogeneously cross-linking reaction with a cross-linking agent, that is, preventing a partial increase in a molecular weight and controlling a molecular weight distribution of the product and a hydrolytic resistance thereof after cross-linking. The end hydroxyl group index is shown by a ratio (%) of a peak area of polyol to a total peak area of monoalcohol and polyol which are analyzed by a gas chromatography. The gas chromatography is analyzed by means of a flame ionization detector (FID), wherein the temperature is elevated from 40°C up to 220°C at 10°C/minute and maintained for 15 minutes.

### Cross-linking agent:

A cross-linking agent for obtaining the cross-linked product of polycaprolactonepolyol and/or polycarbonatepolyol shall not specifically be restricted as long as it is a compound or a polymer having two or more functional groups per molecule which are subjected to cross-linking curing reaction with hydroxyl groups present in the polycaprolactonepolyol and/or the polycarbonatepolyol described above, and at least one of them can suitably be selected and used.
For example, compounds or polymers having a phenol group, an epoxy group, a melamine group, an isocyanate group and a dialdehyde group are shown as the examples of the cross-linking agent. The compounds or the polymers having an epoxy group, a melamine group and an isocyanate group are preferred in terms of a cross-linking reactivity and a pot life, and the isocyanate compounds and/or the epoxy compounds are more preferred in terms of controlling a pot life. In particular, isocyanate compounds are desirable in terms of a reactivity of a component in a two-component reactive coating agents, a weatherability originating therein and a hardness and a flexibility of the coated layer. (b) Cross-linked product of modified polyvinyl alcohol;
The modified polyvinyl alcohol includes resins obtained by modifying a hydroxyl group of polyvinyl alcohol to a silanol group, a silyl group, an amino group, an ammonium group, an alkyl group, an isocyanate group, an oxazoline group, a methylol group, a nitrile group, an acetoacetyl group, a cation group, a carboxyl group, a carbonyl group, a sulfone group, a phosphoric acid group, an acetal group, a ketal group, a carbonate ester group, a cyanoethyl group and the like. Among them, the resins modified to acetacetal and butyral are preferred in terms of a moisture resistance under high temperature and high humidity.
A hydroxyl group remains in the modified polyvinyl alcohols, and therefore cross-linking of the hydroxyl group makes it possible to enhance further the moisture resistance.

### Polyvinyl butyral:

Polyvinyl butyral which is a modified product produced by the butyral modification described above can be prepared by a publicly known method, and polyvinyl butyral having a butyral modification degree of preferably 50 to 80 mol %, more preferably 60 to 75 mol % and an isotactic triad type remaining hydroxyl group amount of preferably 1 mol % or less, more preferably 0.5 mol % or less is preferred in terms of having the good weatherability, enhancing the solvent solubility and obtaining the uniform coating layer.
A weatherability and a solvent solubility of polyvinyl butyral depends on a butyral modification degree, and the butyral modification degree is preferable high. However, polyvinyl alcohol can not be modified to butyral by 100 mol %, and it is not efficient in terms of industrial production to enhance the butyral modification degree to the maximum. Further, the solvent solubility is changed according to the kind of the remaining hydroxyl groups, and if the isotactic triad type hydroxyl group remains more, polyvinyl butyral is inferior in a solubility in an organic solvent.

### Polyvinyl acetacetal:

Polyvinyl acetacetal which is a modified product produced by the acetacetal modification described above can be prepared by a publicly known methods. The high acetal modification degree is desirable in terms of the heat resistance, and the acetal modification degree is preferably 50 to 80 mol %, more preferably 65 to 80 mol % mol %. A suitable amount of aldehyde having 3 or more carbon atoms is preferably mixed to maintain the mixture at a suited temperature after an acetal product is deposited in terms of obtaining a polyvinyl acetacetal resin having a narrow particle diameter distribution in order to enhance a solvent solubility to form the uniform coating layer.

### Cross-linking agent:

A cross-linking agent for obtaining the cross-linked product of modified polyvinyl alcohol shall not specifically be restricted as long as it is a compound or a polymer having two or more functional groups per molecule which are subjected to cross-linking curing reaction, and at least one of them can suitably be selected and used according to the kind of a functional group present in the modified polyvinyl alcohol described above.
For example, when cross-linking the cross-linking agent with a hydroxyl group of the modified polyvinyl alcohol, compounds or polymers having a phenol group, an epoxy group, a melamine group, an isocyanate group and a dialdehyde group are shown as the examples of the crosslinkable compound. The compounds or the polymers having an epoxy group, a melamine group and an isocyanate group are preferred in terms of a cross-linking reactivity and a pot life, and the compounds or the polymers having an isocyanate group are particularly preferred in terms of controlling a pot life.

### (c) Acryl base copolymer having at least one group selected from the group consisting of a UV ray stabilizing group, a UV ray absorbing group and a cycloalkyl group:

In general, a method for providing a polymer with a weatherability includes a method in which a UV ray stabilizing agent and a UV ray absorbing agent are added. The above agents having a relatively low molecular weight bleed out from a principal material in long term use, and a weatherability thereof is less liable to be maintained. In the above weather resistant coating, they can show a weatherability over a long period of time without bleeding-out by copolymerizing a UV ray stabilizing group and a UV ray absorbing group with a cycloalkyl group having a moisture resistance.
In the present invention, the UV ray stabilizing group has a function of capturing generated radicals to inactivate them and includes preferably, to be specific, a hindered amine group in terms of the matter described above. That is, a stable nitroxy radical generated in a hindered amine group is combined with an active polymer radical, and the radical itself returns to the original stable nitroxy radical. This operation is repeated.
Also, the UV ray absorbing group inhibits generation of radicals by absorbing a UV ray radiated, and in terms of the above matter, it includes preferably, to be specific, a benzotriazole group and/or a benzophenone group.
The cycloalkyl group has a function of providing the resin such as the acryl base copolymer and the like constituting the weather resistant coating layer with a moisture resistance and a vapor permeating resistance.

Accordingly, deterioration of a gas barrier in the gas barriering film can be prevented by using for the coating layer, the acryl base copolymer having at least one group selected from the group consisting of a UV ray stabilizing group, a UV ray absorbing group and a cycloalkyl group. In the present invention, a synergistic effect can be obtained in terms of the weatherability by having a UV ray stabilizing group, a UV ray absorbing group and a cycloalkyl group in combination.
The acryl base copolymer described above can be obtained by copolymerizing at least one selected from the group consisting of a polymerizable UV ray stabilizing monomer, a polymerizable UV ray absorbing monomer and cycloalkyl (meth)acrylate.

### Polymerizable UV ray stabilizing monomer:

The polymerizable UV ray stabilizing monomer has preferably a hindered amine group, more preferably each at least one hindered amine group and polymerizable unsaturated group in a molecule.
The polymerizable UV ray stabilizing monomer is preferably a compound represented by the following Formula (1) or (2):

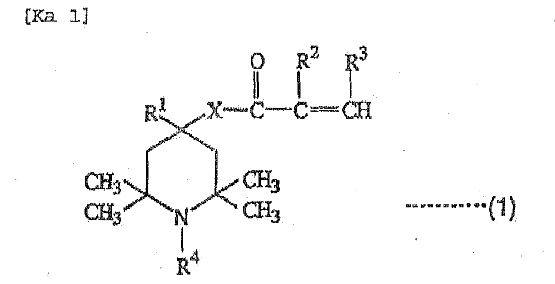

(wherein R¹ represents a hydrogen atom or a cyano group; R² and R³ each represent independently a hydrogen atom or a hydrocarbon group having 1 or 2 carbon atoms; R⁴ represents a hydrogen atom or a hydrocarbon group having 1 to 18 carbon atoms; and X represents an oxygen atom or an imino group) ;

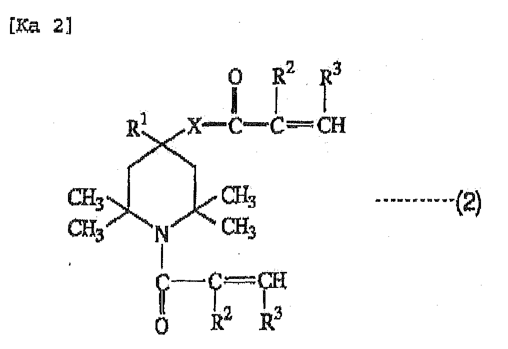

(wherein R¹ represents a hydrogen atom or a cyano group; R² and R³ each represent independently a hydrogen atom or a hydrocarbon group having 1 or 2 carbon atoms; and X represents an oxygen atom or an imino group)

In the polymerizable UV ray stabilizing monomer represented by Formula (1) or (2), the hydrocarbon group having 1 to 18 carbon atoms represented by R⁴ includes, to be specific, chain hydrocarbon groups such as methyl, ethyl, propyl, isopropyl, butyl, isobutyl, t-butyl, pentyl, hexyl, heptyl, octyl, nonyl, decyl, undecyl, dodecyl, tridecyl, tetradecyl, pentadecyl, hexadecyl, heptadecyl, octadecyl and the like; alicyclic hydrocarbon groups such as cyclopropyl, cyclopentyl, cyclohexyl, cycloheptyl, cyclooctyl and the like; and aromatic hydrocarbon groups such as phenyl, tolyl, xylyl, benzyl, phenethyl and the like. Among them, in the present invention, R⁴ is preferably a hydrogen atom and methyl in terms of a light stabilizing reactivity.
The hydrocarbon group having 1 or 2 carbon atoms represented by each of R² and R³ includes, for example, methyl, ethyl and the like, and it is preferably methyl.

The polymerizable UV ray stabilizing monomer represented by Formula (1) includes, to be specific, 4-(meth)acryloyloxy-2,2,6,6-tetramethylpiperidine, 4-(meth)acryloylamino-2,2,6,6-tetramethylpiperidine, 4-(Meth)acryloyloxy-1,2,2,6,6-pentamethylpiperidine, 4-(meth)acryloylamino-1,2,2,6,6-pentamethylpiperidine, 4-cyano-4-(meth)acryloylamino-2,2,6,6-tetramethylpiperidine, 4-crotonoyloxy-2,2,6,6-tetramethylpiperidine, 4-crotonoylamino-2,2,6,6-tetramethylpiperidine and the like. Among them, in the present invention, 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine and 4-(meth)acryloylamino-1,2,2,6,6-pentamethylpiperidine are preferred in terms of a light stabilizing reactivity, and 4-methacryloyloxy-2,2,6,6-tetramethylpiperidine and 4-methacryloyloxy-1,2,2,6,6-pentamethylpiperidine are more preferred. They may be used alone or in a suitable mixture of two or more kinds thereof. It is a matter of course that the polymerizable UV ray stabilizing monomer represented by Formula (1) shall not be restricted to the above compounds.

The polymerizable UV ray stabilizing monomer represented by Formula (2) includes, to be specific, 1-(meth)acryloyl-4-(meth)acryloylamino-2,2,6,6-tetramethylpiperidine, 1-(meth) acryloyl-4-cyano-4-(meth)acryloylamino-2,2,6,6-tetramethylpiperidine, 1-crotonoyl-4-crotonoyloxy-2,2,6,6-tetramethylpiperidine and the like. Among them, in the present invention, 1-acryloyl-4-acryloylamino-2,2,6,6-tetramethylpiperidine and 1-methacryloyl-4-methacryloylamino-2,2,6,6-tetramethylpiperidine are preferred in terms of a raw material versatility, and 1-methacryloyl-4-methacryloylamino-2,2,6,6-tetramethylpiperidine is more preferred. They may be used alone or in a suitable mixture of two or more kinds thereof. The Polymerizable UV ray stabilizing monomer represented by Formula (2) shall not be restricted to the above compounds.
The polymerizable UV ray stabilizing monomer described above is contained in a range of preferably 0.1 to 50 % by mass, more preferably 0.2 to 10 % by mass and further preferably 0.5 to 5 % by mass based on the whole polymerizable monomer components for obtaining the acryl base copolymer in terms of a light stabilizing performance. If the content falls in the ranges described above, the weatherability is sufficiently exerted.

### Polymerizable UV ray absorbing monomer:

The polymerizable UV ray absorbing monomer used in the present invention includes preferably polymerizable benzotriazoles and/or polymerizable benzophenones.

### (a) Polymerizable benzotriazoles:

In the present invention, the polymerizable benzotriazoles are, to be specific, preferably compounds represented by the following Formula (3) and Formula (4):

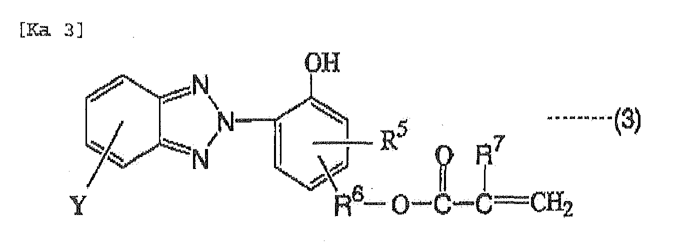

(wherein R⁵ represents a hydrogen atom or a hydrocarbon group having 1 to 8 carbon atoms; R⁶ represents a lower alkylene group; R⁷ represents a hydrogen atom or methyl; and Y represents a hydrogen atom, a halogen atom, a hydrocarbon group having 1 to 8 carbon atoms, a lower alkoxy group, a cyano group or a nitro group);

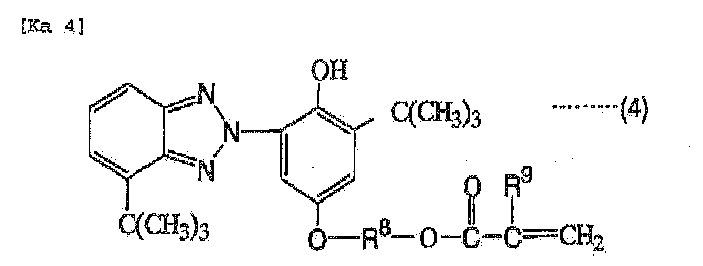

(wherein R⁸ represents an alkylene group having 2 or 3 carbon atoms, and R⁹ represents a hydrogen atom or methyl).

In the formula described above, the hydrocarbon group having 1 to 8 carbon atoms represented by R⁵ includes, to be specific, chain hydrocarbon groups such as methyl, ethyl, propyl, isopropyl, butyl, isobutyl, t-butyl, pentyl, hexyl, heptyl, octyl and the like; alicyclic hydrocarbon groups such as cyclopropyl, cyclopentyl, cyclohexyl, cycloheptyl, cyclooctyl and the like; and aromatic hydrocarbon groups such as phenyl, tolyl, xylyl, benzyl, phenethyl and the like. R⁵ is preferably a hydrogen atom or methyl.

The lower alkylene group represented by R⁶ is preferably an alkylene group having 1 to 6 carbon atoms and includes, to be specific, linear alkylene groups such as methylene, ethylene, propylene, butylene, pentylene, hexylene and the like and branched chain alkylene groups such as isopropylene, isobutylene, s-butylene, t-butylene, isopentylene, neopentylene and the like, and it is preferably methylene, ethylene and propylene.
The substituent represented by Y includes hydrogen; halogens such as fluorine, chlorine, bromine and iodine; the hydrocarbon group having 1 to 8 carbon atoms represented by R⁵; lower alkoxy groups having 1 to 8 carbon atoms such as methoxy, ethoxy, propoxy, butoxy, pentoxy, heptoxy and the like; a cyano group; and a nitro group, and it is preferably a hydrogen atom, a chlorine atom, methoxy, t-butyl, a cyano group and a nitro group in terms of a reactivity.

The Polymerizable UV ray absorbing monomer represented by Formula (3) described above includes, to be specific, 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole, 2-[2'-hydroxy-5'-t-butyl-3'-(methacryloyloxyethyl)phenyl]-2H-benzotriazole, 2-[2'-hydroxy-5'-(methacryloyloxyethyl)phenyl]-5-chloro-2H-benzotriazole, 2-[2'-hydroxy-5'-(methacryloyloxyethyl)phenyl]-5-methoxy-2H-benzotriasole, 2-[2'-hydroxy-5'-(methacryloyloxyethyl)phenyl]-5-cyano-2H-benzotriasole, 2-[2'-hydroxy-5'-(methacryloyloxy-ethyl)phenyl]-t-butyl-2H-benzotriazole, 2-[2'-hydroxy-5'-(methacryloyloxyethyl)phenyl]-5-nitro-2H-benzotriazole and the like. Preferred in terms of a UV ray absorbing property are 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole and 2-[2'-hydroxy-5'-(methacryloyloxyethyl)phenyl]-t-butyl-2H-benzotriazole, and more preferred are 2-[2'-hydroxy-5'-(methacryloyloxymethyl)-phenyl]-2H-benzotriazole and 2- [2'-hydroxy-5'-(methacryloyloxyethyl)phenyl] -2H-benzotriazole. The above polymerizable UV ray absorbing monomers represented by Formula (3) may be used alone or in a suitable mixture of two or more kinds thereof.

In the polymerizable UV ray absorbing monomer represented by Formula (4) described above, the alkylene group having 2 or 3 carbon atoms represented by R⁸ in the formula is, to be specific, ethylene, trimethylene, propylene and the like.
The polymerizable UV ray absorbing monomer represented by Formula (4) described above includes, for example, 2-[2'-hydroxy-5'-(β-methacryloyloxyethoxy)-3'-t-butylphenyl]-4-t-butyl-2H-benzotriazole, 2-[2'-hydroxy-5'-(β-acryloyloxyethoxy)-3'-t-butylpheny]-4-t-butyl-2H-benzotriazole, 2-[2'-hydroxy-5'- (β-methacryloyloxy-n-propoxy)-3'-t-butylphenyl] -4-t-butyl-2H-benzotriazole and 2- [2'-hydroxy-5'- (β-methacryloyloxy-i-propoxy)-3'-t-butylphenyl] -4-t-butyl-2H-benzotriazole, and it is preferably 2-[2'-hydroxy-5'-(β-methacryloyloxyethoxy)-3'-t-butylphenyl]-4-t-butyl-2H-benzotriazole in terms of a UV ray absorbing property. The above polymerizable UV ray absorbing monomers represented by Formula (4) may be used alone or in a suitable mixture of two or more kinds thereof.

### (b) Polymerizable benzophenones:

The polymerizable benzophenones used as the polymerizable UV ray absorbing monomer include, for example, monomers such as 2-hydroxy-4-(3-methacryloyloxy-2-hydroxy-propoxy)benzophenone, 2-hydroxy-4-(3-acryloyloxy-2-hydroxy-propoxy)benzophenone, 2,2'-dihydroxy-4-(3-methacryloyloxy-2-hydroxypropoxy)benzophenone, 2,2'-dihydroxy-4-(3-acryloyloxy-2-hydroxypropoxy)benzophenone and the like which are obtained by reacting 2,4-dihydroxybenzophenone or 2,2',4-trihydroxybenzophenone with glycidyl acrylate or glycidyl methacrylate. They are preferably 2-hydroxy-4-(3-methacryloyloxy-2-hydroxypropoxy)benzophenone in terms of a raw materials versatility.

The polymerizable UV ray absorbing monomer is used in order to further enhance a weatherability, of the coating layer containing the acryl copolymer obtained, and a content thereof in the whole polymerizable monomer components is described below. In a case of the polymerizable benzotriazoles, it is preferably 0.1 to 50 % by mass, more preferably 0.5 to 40 % by mass and further preferably 1 to 30 % by mass in terms of the satisfactory UV ray absorbing performance and prevention of coloring caused by irradiation with a UV ray. In a case of the polymerizable benzophenones, a content thereof is preferably 0.1 to 10 % by mass, more preferably 0.2 to 5.0 % by mass in terms of a satisfactory UV ray absorbing performance and a good compatibility.

### Cycloalkyl (meth)acrylate:

Cycloalkyl (methacrylate used in the present invention is a component used in order to enhance a hardness, an elasticity, a solvent resistance, a gasoline resistance and a weatherability of the coating film when the acryl copolymer obtained is used particularly for a two-component urethane resin coating material. For example, cyclohexyl (meth)acrylate, methylcyclohexyl (meth)acrylate, t-butylcyclohexyl (meth)acrylate, cyclododecyl (meth)acrylate and the like can preferably be listed as the cycloalkyl (meth)acrylate. They can be used alone or in combination of two or more kinds thereof. The above cycloalkyl (meth)acrylate is used in a range of preferably 5 to 80 % by mass, more preferably 10 to 70 % by mass and further preferably 15 to 50 % by mass based on the polymerizable monomer components. If the use amount falls in the ranges described above, the performances of the coating film such as a hardness, a weatherability and the like are sufficiently exerted, and the drying property and the leveling property are compatibly obtained.

### Cross-linking functional group:

In the weather resistant coating layer described above, the acryl base copolymer has a cross-linking functional group and is cross-linked with the cross-linking agent, whereby the cross-linked resin is preferably formed. This provides the acryl base copolymer with a cross-linked structure, and therefore a physical property and a weatherability of the coating layer are enhanced. As a result thereof, the excellent weather resistant performance is maintained over a long- period of time.
The cross-linking functional group contained in the acryl base copolymer described above includes, for example, a hydroxyl group, an amino group, a carboxyl group or an anhydride thereof, an epoxy group, an amide group and the like. The above cross-linking functional groups may be present alone or in a plurality of two or more kinds thereof in the acryl base copolymer. In the present invention, among the above cross-linking functional groups, the groups having active hydrogen such as a hydroxyl group, an amino groups, a carboxyl group and the like are preferred in terms of a stability.

Capable of being listed as the polymerizable unsaturated monomer having a hydroxyl group are, for example, (meth)acryl monomers having a hydroxyl group, such as hydroxyethyl (meth)acrylate, hydroxypropyl (meth)acrylate, caprolactone-modified hydroxy (meth)acrylate and mono(meth)acrylates of polyester diols which are obtained from phthalic acid and propylene glycol, and it is preferably hydroxypropyl acrylate and hydroxyethyl methacrylate. They can be used alone or in combination of two or more kinds thereof.
When the acryl base copolymer obtained is blended with other cross-linking compounds including polyisocyanate to prepare a resin composition for a thermosetting type coating material, the polymerizable monomer containing a cross-linking functional group is a component necessary for reaction with the above cross-linking compounds, and it is used in a range of 2 to 35 % by mass, preferably 3.5 to 23 % by mass based on the whole polymerizable monomer components. If the use amount falls in the ranges described above, an amount of a cross-linking functional group contained in the acryl base copolymer obtained is suitable; a reactivity of the above acryl base copolymer with the cross-linking compound is maintained, the cross-linking density is satisfactory; and the targeted coating film performances are obtained. Further, the storage stability after blended with the cross-linking compound is good.

### Other polymerizable unsaturated monomers:

In the present invention, other polymerizable unsaturated monomers for forming the acryl base copolymer can be used.
The other polymerizable unsaturated monomers used in the present invention include, for example, (meth)acrylic acid alkyl esters such as methyl (meth)acrylate, ethyl (meth)acrylate, propyl (meth)acrylate, isopropyl (meth)acrylate, butyl (meth)acrylate, isobutyl (meth)acrylate, tertiary butyl (meth)acrylate, 2-ethylhexyl (meth)acrylate, lauryl (meth)acrylate, stearyl (meth)acrylate and the like; epoxy group-containing unsaturated monomers such as glycidyl (meth)acrylate and the like; nitrogen-containing unsaturated monomers such as (meth)acrylamide, N,N'-dimethylaminoethyl (meth)acrylate, vinylpyridine, vinylimidazole and the like; halogen-containing unsaturated monomers such as vinyl chloride, vinylidene chloride and the like; aromatic unsaturated monomers such as styrene, α-methylstyrene, vinyl toluene and the like; vinyl esters such as vinyl acetate and the like; vinyl ethers; and unsaturated cyan compounds such as (meth)acrylonitrile and the like. At least one monomer selected from the above groups can be used.

Further, a polymerizable unsaturated monomer having an acid functional group can be used as well in terms of an internal catalytic action in cross-linking reaction, and capable of being listed are, for example, carboxyl group-containing unsaturated monomers such as (meth)acrylic acid, crotonic acid, itaconic acid, maleic acid, maleic anhydride and the like; sulfonic acid group-containing unsaturated monomers such as vinylsulfonic acid, styrenesulfonic acid, sulfoethyl (meth)acrylate and the like; and acid phosphoric acid ester base unsaturated monomers such as 2-(meth)acryloyloxyethyl acid phosphate, 2-(meth) acryloyloxypropyl acid phosphate, 2- (meth) acryloyloxy-2-chloropropyl acid phosphate, 2-(meth)acryloyloxyethylphenyl phosphate and the like. At least one compound selected from the above groups can be used.
The other polymerizable unsaturated monomers described above can be used, if necessary, as long as the actions of the acryl base copolymers in the method of the present invention are not damaged, and a use amount thereof can be 0 to 92.9 % by mass based on the polymerizable monomer components. Also, the Polymerizable monomers having an acid functional group among the other Polymerizable unsaturated monomers function as an internal catalyst used when the acryl base copolymer is subjected to cross-linking reaction with the cross-linking agent, and an amount thereof can be 0 to 5 % by mass, preferably 0.1 to 3 % by mass based on the polymerizable monomer components.

### Polymerization method of the acryl base copolymer:

A method for obtaining the acryl base copolymer by using the monomers described above shall not specifically be restricted, and publicly known polymerization methods can be used.
For example, when a solution polymerization method is used, capable of being listed as solvents which can be used are, for example, aromatic solvents having a high boiling point, such as toluene, xylene and the like; ester base solvents such as ethyl acetate, butyl acetate, cellosolve acetate, propylene glycol monomethyl ether acetate and the like; ketone base solvents such as methyl ethyl ketone, methyl isobutyl ketone and the like; aliphatic alcohols such as isopropanol, n-butanol, isobutanol and the like; and alkylene glycols monoalkyl ethers such as propylene glycol monomethyl ether, propylene glycol monoethyl ether, diethylene glycol monoethyl ether and the like, and they can be used alone or in a mixture of two or more kinds thereof.
Also, capable of being listed as the polymerization initiator are usual radical polymerization initiators such as 2,2'-azobis-(2-methylbutyronitrile), t-butylperoxy-2-ethyl hexanoate, 2,2'-azobisisobutyronitrile, benzoyl peroxide, di-t-butyl peroxide and the like. They may be used alone or in combination of two or more kinds thereof. A use amount thereof shall not specifically be restricted and can suitably be set according to the characteristics of the desired acryl resin.
The reaction conditions such as the reaction temperature, the reaction time and the like shall not specifically be restricted, and for example, the reaction temperature falls in a range of room temperature to 200°C, preferably 40 to 140°C. The reaction time can suitably be set according to a composition of the monomer components and the kind of the polymerization initiator so that the polymerization reaction is completed.

### Cross-linking agent:

The Cross-linking agent shall not specifically be restricted as long as it is a compound or a polymer having two or more functional groups per molecule which are subjected to cross-linking curing reaction with the cross-linking functional groups described above, and at least one of them can suitably be selected and used according to the kind of a functional group contained in the acryl base copolymer described above.
If a functional group contained in the acryl base copolymer is, for example, a hydroxyl group, compounds or polymers having a phenol group, an epoxy group, a melamine group, an isocyanate group and a dialdehyde group are shown as the examples of the cross-linking agent. The compounds or the polymers having an epoxy group, a melamine group and an isocyanate group are preferred in terms of a cross-linking reactivity and a pot life, and the compounds or the polymers having an isocyanate group are particularly preferred in terms of controlling a pot life.
When a cross-linking functional group contained in the acryl base copolymer is a carboxyl group or an anhydride thereof, the cross-linking agent includes cross-linking compounds such as polyisocyanate compounds or modified products thereof, aminoplast resins, epoxy resins and the like, and when the cross-linking functional group is an epoxy group, it includes cross-linking agents containing compounds such as amines, carboxylic acids, amides, N-methylolalkyl ethers and the like. When the cross-linking functional group is a hydroxyl group and an amino group, it includes cross-linking agents such as polyisocyanate compounds or modified products thereof, epoxy resins, aminoplast resins and the like. Among them, it is preferably the polyisocyanate compound and/or the epoxy resin in combination with groups having active hydrogen.
In the acryl base copolymer described above, combination in which the cross-linking functional group is a hydroxyl group and in which the cross-linking agent is the isocyanate compound is preferred as a two-component reactive coating agent in terms of a reactivity of the components and a weatherability originating therein and a hardness and a flexibility of the coating layer.

### Cross-linking agent in weather resistant coating layer:

As described above, the isocyanate compound as the cross-linking agent is preferably used for a weather resistant coat of the gas barriering layer, and polyisocyanate is preferably used as the isocyanate compound. The polyisocyanate may be one of diisocyanate, dimers thereof (uretdione), trimers thereof (isocyanurate, triol adducts, burets) and the like or a mixture of two or more kinds thereof. The diisocyanate component includes, for example, 2,4-tolylenediisocyanate, 2,6-tolylenediisocyanate, p-phenylenediisocyanate, diphenylmethanediisocyanate, m-phenylenediisocyanate, hexamethylenediisocyanate, tetramethylenediisocyanate, 3,3'-dimethoxy-4,4'-biphenylenediisocyanate, 1,5-naphthalenediisocyanate, 2,6-naphthalenediisocyanate, 4,4'-diisocyanate diphenyl ether, 1,5-xylylenediisocyanate, 1,3-diisocyanatemethylcyclohexane, 1,4-diisocyanatemethylcyclohexane, 4,4'-diisocyanatecyclohexane, 4,4'-diisocyanatecyclohexylmethane, isophoronediisocyanate, dimer acid diisocyanate, norbornenediisocyanate and the like. Further, diisocyanates of a xylylenediisocyanate (XDI) base, an isophoronediisocyanate (IPDI) base, a hexamethylenediisocyanate (HDI) base and the like are preferred in terms of a no-yellowing property. Also, an isocyanurate body and a buret body of hexamethylenediisocyanate are good in terms of a fastness, a gas barriering property and a weatherability.

The epoxy compound shall not specifically be restricted as long as it is a compound having two or more epoxy groups in a molecule and includes, for example, sorbitol polyglycidyl ether, sorbitan polyglycidyl ether, polyglycerol polyglycidyl ether, pentaerythritol polyglycidyl ether, triglycidyl, tris(2-hydroxyethyl) isocyanurate, neopentyl glycol diglycidyl ether, 1,6-hexanediol diglycidyl ether, ethylene glycol diglycidyl ether, epoxy resins of a bisphenol A type and the like.
A use amount of the cross-linking agents described above shall not specifically be restricted and can suitably be determined according to the kind and the like of the cross-linking agents, and a reactive group ratio of the cross-linking groups (for example, a hydroxyl group) of the polycaprolactonepolyol, the polycarbonatepolyol, the modified polyvinyl alcohol and the acryl base copolymer each described above to the cross-linking groups of the cross-linking compounds is desirably the hydroxyl group : the cross-linking group =1 : 1 to 1 : 20, preferably 1 : 1 to 1 : 10 in terms of the in-layer coagulation, power and the interlayer adhesive property. If the cross-linking group ratio falls in the ranges described above, it is advantageous in terms of the adhesive property, the high temperature & high humidity resistance, the gas barriering property, the blocking resistance and the like.
Further, at least one of cross-linking catalysts such as salts, inorganic substances, organic substances, acid substances, alkali substances and the like may be added to the cross-linking agent described above in order to accelerate the cross-linking reaction. For example, when the polyisocyanate compound is used as the cross-linking agent, addition of at least one of publicly known catalysts such as dibutyltin dilaurate, tertiary amine and the like is shown as an example thereof.
Further, a silane base coupling agent, a titanium base coupling agent, a light blocking agent, a UV absorber, a stabilizing agent, a lubricant, a blocking inhibitor, an antioxidant and the like can be added, and compounds obtained by copolymerizing them with the resins described above can be used.

### Method for forming the weather resistant coating layer:

The weather resistant coating layer can be formed by suitably employing publicly known coating methods. For example, any of methods such as a reverse roll coater, a gravure coater, a rod coater, an air doctor coater, a coating method using a spray or a brush and the like can be used. After coating, the solvent can be evaporated by using a publicly known drying method including heat drying such as hot air drying at a temperature of 80 to 200°C and hot roll drying, infrared drying and the like. Also, cross-linking treatment carried out by irradiation with an electron beam can be carried out as well in order to enhance the moisture resistance and the durability.
A thickness of the weather resistant coating layer is 0.005 to 5 µm, preferably 0.01 to 1 µm. If the thickness is 5 µm or less as described above, the lubricity is good, and peeling of the weather resistant coating layer itself from the base material film by an internal stress is scarcely brought about. Also, if the thickness is 0.005 µm or more, the even thickness can be maintained, and it is preferred.
Further, flattening of a surface of the base material film by the weather resistant coating layer allows particles for forming the inorganic thin film layer to be accumulated minutely and makes it easy to form the layer in an even thickness, and therefore the high gas barriering property can be obtained.

### Inorganic thin film layer:

An inorganic substance constituting the inorganic thin film layer includes silicon, aluminum, magnesium, zinc, tin, nickel, titanium, carbon hydride or oxides, carbides and nitrides thereof and mixtures thereof, and it is preferably silicon oxide, aluminum oxide and diamondlike carbon comprising principally carbon hydride. In particular, silicon oxide, silicon nitride, silicon oxynitride and aluminum oxide are preferred in terms of enabling to maintain stably the high gas barriering property.
A material gas which can be used for chemical gas phase vapor deposition comprises preferably at least one kind of gas. In forming, for example, a silicon compound thin film, a first raw material gas containing silicon and a second raw material gas such as ammonia, nitrogen, oxygen, hydrogen and rare gas including argon are preferably used. Monosilane, tetramethoxysilane, methyltrimethoxysilane, dimethyldimethoxysilane, phenyltrimethoxysilane, diphenyldimethoxysilane, tetraethoxysilane, methyltriethoxysilane, dimethyldiethoxysilane, phenyltriethoxysilane, diphenyldiethoxysilane, hexyltrimethoxysilane, hexyltriethoxysilane, decyltrimethoxysilane, decyltriethoxysilane, trifluoropropyltrimethoxysilane, hexamethyldisiloxane, hexamethyldisilazane and the like can be used alone or in combination of two kinds thereof as the first raw material gas containing silicon. Also, the raw material gas may be either liquid or gas at room temperature, and the liquid raw material can be supplied into the apparatus by vaporizing by means of a raw material vaporizing equipment. In a catalytic chemical gas phase growing method, a monosilane gas is preferred in terms of deterioration of the heated catalyst, a reactivity and a reaction rate.

Any of methods such as a vapor deposition method, a coating method and the like can be used as a method for forming the inorganic thin film layer of the gas barriering film, and the vapor deposition method is preferred in terms of obtaining the even thin film having a high gas barriering property. Methods such as physical vapor phase deposition (PVD) and chemical vapor phase deposition (CVD) are included in the above vapor deposition method. The physical vapor phase deposition method includes vacuum vapor deposition, ion plating, sputtering and the like, and the chemical vapor phase deposition method includes plasma CVD making use of plasma and a catalytic chemical gas phase growing method (Cat-CVD) in which a material gas is subjected to catalytic heat decomposition using a heated catalyst.
Further, the inorganic thin film layer is turned preferably into a multilayer in terms of enabling to maintain and secure stably the high gas barriering property over a long period of time under severe environment. In such case, various publicly known film forming methods may be combined. Included therein is, for example, a multilayer inorganic thin film constitution in which a vacuum vapor deposition film/a vacuum vapor deposition film, a vacuum vapor deposition film/a plasma CVD film, a vacuum vapor deposition film/plasma treatment/a vacuum vapor deposition film, a vacuum vapor deposition film/a plasma CVD film/a vacuum vapor deposition film, a vacuum vapor deposition film/a Cat-CVD film/a vacuum vapor deposition film, a vacuum vapor deposition film/a weather resistant coat/a vacuum vapor deposition film, a plasma CVD film/a vacuum vapor deposition film, a plasma CVD film/a vacuum vapor deposition film/a plasma CVD film or the like is formed in order on the weather resistant coating layer. Among them, a multilayer of a vacuum vapor deposition film/a plasma CVD film is preferred in terms of a good gas barriering property, an adhesive property and a productivity.
A thickness of each inorganic thin film layer is usually 0.1 to 500 nm, preferably 0.5 to 100 nm and more preferably 1 to 50 nm. If the thickness falls in the ranges described above, the sufficiently high gas barriering property is obtained, and the productivity is excellent without bringing about cracking and peeling on the inorganic thin film layer.

### Protective layer for the gas barriering layer:

A protective layer may be provided on the gas barriering layer in order to protect the inorganic thin film layer described above. Either of a solvent-soluble resin and a water-soluble resin can be used as a resin for forming the above protective layer, and to be specific, polyester base resins, urethane base resins, acryl base resins, polyvinyl alcohol base resins, ethylene vinyl alcohol base resins, vinyl-modified resins, nitrocellulose base resins, silicone base resins, isocyanate base resins, epoxy base resins, oxazoline group-containing resins, modified styrene base resins, modified silicone base resins, alkyl titanate and the like can be used alone or in combination of two or more kinds thereof. Further, a layer obtained by mixing at least one kind of inorganic particles selected from a silica sol, an alumina sol, a particulate inorganic filler and a stratiform inorganic filler with at least one kind of the resins described above in order to improve a barriering property, a frictional property and a lubricity or a layer comprising an inorganic particle-containing resin formed by polymerizing a raw material of the resin described above under the presence of the above inorganic particles can be used as the protective layer.
The resin for forming the protective layer is preferably the water-soluble resin described above in terms of enhancing a gas barriering property of the inorganic thin film layer. Further, the water-soluble resin is preferably a vinyl alcohol base resin or an ethylene vinyl alcohol resin. Also, a resin layer prepared by coating an aqueous solution containing polyvinyl alcohol and an ethylene-unsaturated carboxylic acid copolymer can be used as the protective layer.
A thickness of the protective layer is preferably 0.05 to 10 µm, more preferably 0.1 to 3 µm in terms of the printing property and the processability. Publicly known coating methods are suitably selected as a forming method therefor. For example, any of methods such as a reverse roll coater, a gravure coater, a rod coater, an air doctor coater, a coating method using a spray or a brush and the like can be used. Also, it may be carried out by dipping the deposited film in a resin solution for the protective layer. After coating, moisture can be evaporated by using a publicly known drying method including heat drying such as hot air drying and hot roll drying at a temperature of 80 to 200°C, infrared drying and the like. Further, cross-linking treatment carried out by irradiation with an electron beam can be carried out as well in order to enhance the moisture resistance and the durability.

### Gas barriering layer:

The gas barriering layer is used preferably in the form of a gas barriering film, and for example, the gas barriering film prepared by providing the weather resistant coating layer, the inorganic thin film layer and, if necessary, the protective layer on the base material film is more preferred.
In the present invention, 2 to 8 layers of the above gas barriering layer are preferably laminated in order to enhance a gas barriering property of the back sheet for a solar battery and maintain it over a long period of time under severe environment, and 2 to 4 layers thereof are more preferably laminated. The constitutions of the respective gas barriering layers used for lamination may be the same or different and can be used in suitable combinations according to the specifications of the back sheet, such as a gas barriering performance, a thickness and the like.
Further, the gas barriering layer can be subjected to heat treatment at 60°C or higher for 24 hours or longer after forming the inorganic thin film layer and/or forming the protective layer and/or laminating the plural gas barriering films. The above heat treatment makes it possible to enhance and stabilize the gas barriering property.
A thickness of the whole gas barriering layer is preferably 5 to 150 µm, more preferably 10 to 100 µm in terms of the gas barriering property and the long term stability thereof.

### <other films>

In the back sheet for a solar battery according to the present invention, a dielectric breakdown voltage of 1 kV or more in terms of a voltage resistant characteristic is desirably satisfied. In the above case, a whole thickness of the back sheet has to be about 200 µm or more and 250 µm or more.
When any or each thickness of the light shielding colored layer, the gas barriering layer and the weather resistant polyester base resin layer is small, other plastic films can be laminated between any of the light shielding colored layer, the gas barriering layer and the weather resistant polyester base resin layer in order to provide the back sheet with a satisfactory voltage resistance, a satisfactory mechanical strength, a satisfactory flame retardant property and the like.
Capable of being used as the above other layers are, for example, those optionally selected from films or sheets of publicly known resins such as low density polyethylene, middle density polyethylene, high density polyethylene, linear low density polyethylene, polypropylene, ethylene-propylene copolymers, ethylene-vinyl acetate copolymers or saponified products thereof, ionomer resins, ethylene-ethyl acrylate copolymer, ethylene-acrylic acid or methacrylic acid copolymers, polymethylpentene base resins, polyester base resins, polybutene base resins, polyvinyl chloride base resins, polyvinyl acetate base resins, polyvinylidene chloride base resins, polyvinyl chloride-vinylidene chloride copolymers, poly(meth)acryl base resins, polyacrylonitrile base resins, polystyrene base resins, acrylonitrile-styrene copolymers (AS base resins), acrylonitrile-butadiene-styrene copolymers (ABS base resins), polyester base resins, polyamide base resins, polycarbonate base resins, polyvinyl alcohol base resins or saponified products thereof, fluorine base resins, diene base resins, polyacetal base resins, polyurethane base resins, nitrocellulose and the like. In the present invention, a film comprising polypropylene, a polyester base resin and a fluorine base resin is preferably provided from the viewpoints of a voltage resistance and a strength. In particular, a polyester base resin film which is excellent in a voltage resistance and has a rigidity is preferably provided between the light shielding colored layer and the gas barriering layer. A thickness thereof shall not be restricted and is preferably 10 to 200 µm, more preferably 20 to 150 µm for the purpose of providing the film with a voltage resistance, a mechanical strength and a flame retardant property which are required to the back sheet.

### <Adhesive>

In the back sheet for a solar battery according to the present invention, the light shielding colored layer, the gas barriering layer, the weather resistant polyester base resin layer and, if necessary, the other films each described above can be laminated respectively by a method such as dry lamination and the like. When an adhesive is used in the lamination, the kind of the adhesive which can be used includes, for example, polyvinyl acetate base adhesives, polyacrylic acid ester base adhesives comprising homopolymers of ethyl, butyl or 2-ethylhexyl ester of acrylic acid or copolymers of the esters described above with methyl methacrylate, acrylonitrile, styrene and the like, cyanoacrylate base adhesives, ethylene copolymer base adhesives comprising copolymers of ethylene with monomers such as vinyl acetate, ethyl acrylate, acrylic acid, methacrylic acid and the like, polyolefin base adhesives comprising polyethylene base resins or polypropylene base resins, cellulose base adhesives, polyester base adhesives, polyether base adhesives, polyamide base adhesives, polyimide base adhesives, amino resin base adhesives comprising urea resins or melamine resins, phenol resin base adhesives, epoxy resin base adhesives, polyurethane base adhesive, reactive (meth)acryl base adhesives, rubber base adhesives comprising chloroprene rubber, nitrile rubber, styrene-butadiene rubber, styrene-isoprene rubber and the like and silicone base adhesives.

Among them, preferred in terms of a hydrolytic resistance are adhesive compositions prepared by blending 1 to 50 parts by mass of at least one compound selected from carbodiimide compounds, oxazoline compounds and epoxy compounds with 100 parts by mass of a single substance of either polyesterpolyol or polyesterurethanepolyol subjected to chain extension by a difunctional or more isocyanate compound or a mixture thereof and/or a single substance of either polycarbonatepolyol or polycarbonateurethanepolyol subjected to chain extension by a difunctional or more isocyanate compound or a mixture thereof and/or a composition prepared by blending a cross-linking agent with acrylpolyol in which a hydroxyl group is introduced into a side chain.

The polyesterpolyol described above can be obtained by using at least one of aliphatic acids such as succinic acid, glutaric acid, adipic acid, pimelic acid, suberic acid, azelaic acid, sebacic acid, brassilic acid and the like and aromatic dibasic acids such as isophthalic acid, terephthalic acid, naphthalenedicarboxylic acid and the like and at least one of aliphatic diols such as ethylene glycol, propylene glycol, butanediol, neopentyl glycol, methylpentanediol, hexanediol, heptanediol, octanediol, nonanediol, decanediol, dodecanediol and the like, alicyclic diols such as cyclohexanediol, hydrogenated xylylene glycol and the like and aromatic diols such as xylylene glycol and the like. Further, it includes polyesterurethanepolyol obtained by subjecting hydroxyl groups at both ends of the above polyesterpolyols to chain extension with a single substance of an isocyanate compound selected from, for example, 2,4- or 2,6-tolylenediisocyanate, xylylenediisocyanate, 4,4'-diphenylmethanediisocyanate, methylenediisocyanate, isopropylenediisocyanate, lisinediisocyanate, 2,2,4- or 2,4,4-trimethylhexamethylenediisocyanate, 1,6-hexamethylenediisocyanate, methylcyclohexanediisocyanate, isophoronediisocyanate, 4,4'-dicyclohexylmethanediisocyanate, isopropylidenedicyclohexyl-4,4'-diisocyanate and the like or an adduct body, a buret body and an isocyanurate body comprising at least one selected from the isocyanate compounds described above.
The isocyanate compounds described above can be used as the cross-linking agent for cross-linking the polyesterpolyols, and it shall not be restricted to them and is irrespective of the kind as long as they are cross-linking agents having a reactivity with an active hydrogen group.

The carbodiimide compound blended in order to block carboxyl groups produced when various polyols are hydrolyzed under accelerating environment at high temperature and high humidity includes N,N'-di-o-toluylcarbodiimide, N,N'-diphenylcarbodiimide, N,N'-di-2,6-dimethylphenylcarbodiimide, N,N'-bis(2,6-diisopropylphenyl)carbodiimide, N,N'-dioctyldecylcarbodiimide, N-toluyl-N'-cyclohexylcarbodiimide, N,N'-di-2,2-di-tert-butylphenylcarbodiimide, N-toluyl-N'-phenylcarbodiimide, N,N'-di-p-nitrophenylcarbodiimide, N,N'-di-p-aminophenylcarbodiimide, N,N'-di-p-hydroxyphenylcarbodiimide, N,N'-di-cyclohexylcarbodiimide, N,N'-di-p-toluylcarbodiimide and the like.
The oxazoline compound having the same function includes monoxazoline compounds such as 2-oxazoline, 2-methyl-2-oxazoline, 2-phenyl-2-oxazoline, 2,5-diphenyl-2-oxazoline, 2,4-diphenyl-2-oxazoline and the like and dioxazoline compounds such as 2,2'-(1,3-phenylene)-bis(2-oxazoline), 2,2'-(1,2-ethylene)-bis(2-oxazoline), 2,2'-(1,4-butylene)-bis(2-oxazoline), 2,2'-(1,4-phénylène)-bis(2-oxazoline) and the like.

similarly, the epoxy compound includes diglycidyl ethers of aliphatic diols such as 1,6-hexanediol, neopentyl glycol, polyalkylene glycol and the like, polyglycidyl ethers of aliphatic polyols such as sorbitol, sorbitan, polyglycerol, pentaerythritol, diglycerol, glycerol, trimethylolpropane and the like, polyglycidyl ethers of alicyclic polyols such as cyclohexanedimethanol and the like, diglycidyl esters or polyglycidyl esters of aliphatic and aromatic polyvalent carboxylic acids such as terephthalic acid, isophthalic acid, naphthalenedicarboxylic acid, trimellitic acid, adipic acid, sebacic acid and the like, diglycidyl ethers or polyglycidyl ethers of polyhydric phenols such as resorcinol, bis-(p-hydroxyphenyl)methane, 2,2-bis-(p-hydroxyphenyl)propane, tris(p-hydroxyphenyl)methane, 1,1,2,2-tetrakis(p-hydroxyphenyl)ethane and the like, N-glycidyl derivatives of amines such as N,N-diglycidylaniline, N,N-diglycidyltoluidine, N,N,N',N'-tetraglyciclyl-bis-(p-aminophenyl)methane and the like, triglycidyl derivatives of aminophenol, triglycidyl tris(2-hydroxyethyl)isocyanurate, triglycidyl isocyanurate, orthocresol type epoxy and phenol novolac type epoxy.
The carbodiimide compound, the oxazoline compound and the epoxy compound which are blended with the adhesive are blended preferably in an amount of 1 to 50 parts by mass based on 100 parts by mass of a composition prepared by blending various polyols with the cross-linking agent in terms of a hydrolytic resistance, an adhesive property and a coating workability of the adhesive layer.

Further, a compound bringing about cross-linking reaction starting from a hydroxyl group produced by hydrolysis may be blended. The above compound includes phosphorus base compounds, and capable of being used are tris(2,4-di-t-butylphenyl) phosphite, tetrakis(2,4-di-t-butylphenyl) 4,4'-biphenylenephosphonite, bis(2,4-di-t-butylphenyl) pentaerythritol-di-phosphite, bis(2,6-di-t-butyl-4-methylphenyl) pentaerythritol-di-phosphite, 2,2-methylenebis(4,6-di-t-butylphenyl)octyl phosphite, 4,4'-butylidene-bis(3-methyl-6-t-butylphenyl-di-tridecyl) phosphite, 1,1,3-tris (2-methyl-4-ditridecylphosphite-5-t-butylphenyl)butane, tris (mixed mono- and dinonylphenyl) phosphite, tris(nonylphenyl) phosphite, 4,4'-isopropylidenebis(phenyl-dialkylphosphite) and the like. However, since it is more essential in terms of inhibiting hydrolysis of the polyester compound to block a carboxyl group functioning as a catalyst than to cross-link further a hydroxyl group once produced by hydrolysis with the phosphorus compound, the carbodiimide compound, the oxazoline compound and the epoxy compound each described above are preferred, and the most preferred compound includes the carbodiimide compound.
The polycarbonatepolyol can be obtained by reacting, for example, a carbonate compound with diol. Dimethyl carbonate, diphenyl carbonate, ethylene carbonate and the like can be used as the carbonate compound. Capable of being used are polycarbonatepolyols obtained by using as the diol, a mixture of at least one of aliphatic diols such as ethylene glycol, propylene glycol, butanediol, neopentyl glycols, methylpentanediol, hexanediol, heptanediol, octanediol, nonanediol, decanediol, dodecanediol and the like, alicyclic diols such as cyclohexanediol, hydrogenated xylylene glycol and the like and aromatic diols such as xylylene glycol and the like, or polycarbonateurethanepolyols subjected to chain extension with the isocyanates compound described above. In particular, the aliphatic polycarbonatepolyols are preferably used considering the performances of the adhesive.

Used as the acryl polyol are polymers comprising essential components of hydroxyl group-containing monomers such as 2-hydroxyethyl (meth)acrylate, 2-hydroxypropyl (meth)acrylate and the like and principal components of (meth)acrylic acid and alkyl (meth)acrylate base monomers having an alkyl group such as methyl, ethyl, n-propyl, i-propyl, n-butyl, i-butyl, t-butyl, 2-ethylhexyl and cyclohexyl, and capable of being further used are copolymers obtained by copolymerizing amide group-containing monomers such as (meth)acrylamide, N-alkyl(meth)acrylamide, N,N-dialkyl(meth)acrylamide (the alkyl group includes methyl, ethyl, n-propyl, i-propyl, n-butyl, i-butyl, t-butyl, 2-ethylhexyl, cyclohexyl and the like), N-alkoxy(meth)acrylamide, N,N-dialkoxy(meth)acrylamide (the alkoxy group includes methoxy, ethoxy, butoxy, isobutoxy and the like), N-methylol(meth)acrylamide, N-phenyl(meth)acrylamide and the like and glycidyl group-containing monomers such as glycidyl (meth)acrylate, allyl glycidyl ether and the like. Further, capable of being used are copolymers obtained by copolymerizing monomers such as vinyl isocyanate, allyl isocyanate, styrene, α-methylstyrene, vinyl methyl ether, vinyl ethyl ether, maleic acid, alkyl maleic acid monoesters, fumaric acid, alkyl fumaric acid monoesters, itaconic acid, alkyl itaconic acid monoesters, (meth)acrylonitrile, vinylidene chloride, ethylene, propylene, vinyl chloride, vinyl acetate, butadiene and the like.
Additives such as a UV absorber, a light stabilizer, an inorganic filler, a colorant and the like can be added to the adhesive as long as an influence is not exerted on an adhesive force.
Also, an adhesive layer can be formed by coating the adhesive described above by a publicly known coating method such as roll coating, gravure coating, kiss coating and the like.
A coating amount is preferably 0.1 to 15 g/m² in terms of a dried film thickness.

### <Back sheet for solar battery>

The back sheet for a solar battery according to the present invention comprises the light shielding colored layer, the weather resistant polyester base resin layer and the gas barriering layer provided between the above layers, and to be specific, the following constitution is preferably employed.
(A) A film comprising the light shielding colored layer/a film comprising the gas barriering layer containing the weather resistant coating layer and the inorganic thin film layer/a film comprising the weather resistant polyester base resin layer.
(B) A film comprising the light shielding colored layer and the gas barriering layer containing the weather resistant coating layer and the inorganic thin film layer/a film comprising the weather resistant polyester base resin layer.
(C) A film comprising the light shielding colored layer/a film comprising the gas barriering layer containing the weather resistant coating layer and the inorganic thin film layer and the weather resistant polyester base resin layer.
In the film comprising the light shielding colored layer and the gas barriering layer containing the weather resistant coating layer and the inorganic thin film layer in the constitution (B) described above, the base material of the gas barriering layer doubles as the light shielding colored layer, and the gas barriering layer has to be provided at a side of the film comprising the weather resistant polyester base resin layer. In this case, a thickness of the above film is preferably 20 to 300 µm, more preferably 50 to 250 µm.

In the film comprising the gas barriering layer containing the weather resistant coating layer and the inorganic thin film layer and the weather resistant polyester base resin layer in the constitution (C) described above, the base material of the gas barriering layer doubles as the weather resistant polyester base resin layer, and the gas barriering layer has to be provided at a side of the film comprising the light shielding colored layer. In this case, a thickness of the above film is preferably 10 to 300 µm, more preferably 20 to 200 µm.
In the constitutions of (A) to (C) described above, the respective layers can be laminated by a method such as dry lamination and the like.

A thickness of the back sheet for a solar battery according to the present invention is 50 to 750 µm, preferably 100 to 500 µm and more preferably 200 to 400 µm in terms of a strength, a durability, a voltage resistance and a cost.
When the light shielding colored layer is white, a whiteness degree of the back sheet is measured by a Hunter method, JIS L1015, and a value thereof is preferably 75 % or more, more preferably 80 % or more in terms of enhancing a power generation efficiency of the solar battery.
A water vapor transmission rate of the back sheet for a solar battery after stored at 85°C and 85 RH % for 1000 hours is preferably 1.0 g/m²/day or less, more preferably 0.8 g/m²/day or less. Further, a water vapor transmission rate of the back sheet for a solar battery after stored at 85°C and 85 RH % for 2000 hours is preferably 2.0 g/m²/day or less, more preferably 1.0 g/m²/day or less.
A shrinkage rate of the back sheet for a solar battery in heating at 150°C for 30 minutes is preferably 3 % or less, more preferably 1 % or less and further preferably 0.5 % or less. If the shrinkage rate is high, inferior lamination is brought about in heating and pressure bonding in a lamination step of preparing the solar battery module.

### <Solar battery module>

The present invention relates to the solar battery module comprising the back sheet of the present invention.
In the solar battery module of the present invention, a transparent substrate, a filler, a solar battery device, a filler and the above back sheet for a solar battery are laminated in order from a sunlight receiving side.
Glass or a sheet and/or a film of a plastic are used as the transparent substrate. When it is a plastic, for the purpose of providing it with a gas barriering property, an inorganic thin film can be formed thereon in the same manner as in the gas barriering film constituting the above back sheet for a solar battery. For the purpose of improving the heat resistance, the weatherability, the mechanical strength, the electrification, the dimensional stability and the like, a cross-linking agent, an antioxidant, a light stabilizer, a UV absorber, an antistatic agent, reinforcing fibers, a flame retardant, an antiseptic agent and the like can be added thereto, and various sheets and/or films can be laminated thereon. A thickness of the transparent substrate can suitably be set in terms of a strength, a gas barriering property, a durability and the like.

Various resins having in combination a light transmitting property, a shock absorbing property and an adhesive property with the transparent substrate, the solar battery device and the back sheet for a solar battery can be used for the filler. They include, for example, fluorine base resins, ethylene-vinyl acetate copolymers, ionomer resins, unsaturated carboxylic acid-modified polyolefin base resins, polyvinylbutyral base resins, silicone base resins, epoxy base resins, acryl base resins and the like. Further, a cross-linking agent, an antioxidant, a light stabilizer, a UV absorber and the like can be added to the filler layer. A thickness thereof can suitably be set according to the required physical properties.
The solar battery device is arranged and wired between the fillers. It includes, for example, a monocrystalline silicon type, a polycrystalline silicon type, an amorphous silicon type, a various compound semiconductor type, a dye sensitizing type, an organic thin film type and the like.
A method for producing the solar battery module shall not specifically be restricted and comprises usually a step of laminating the transparent substrate, the filler, the solar battery device, the filler and the back sheet for a solar battery in this order and a step of subjecting them to vacuum aspiration and heating and pressing them under vacuum.
The solar battery module is excellent in a weatherability, a durability, a low cost and a low weight because of an excellent weatherability and an excellent long term gas barriering property of the back sheet for a solar battery, and therefore it can suitably be used for various applications regardless of small-sized, large-sized, indoor and outdoor applications.

### EXAMPLES

Next, the present invention shall more specifically be explained with reference to examples, but the present invention shall by no means be restricted by these examples.
The performances of the back sheets for a solar battery obtained in the respective examples were evaluated in the following manners.

### <Composition ratio of inorganic thin film>

An elemental composition of the inorganic thin film of the gas barriering film obtained was analyzed by means of ESCA-3400 manufactured by Shimadzu Corporation.

### <Thickness of inorganic thin film>

The gas barriering film obtained was embedded in a resin, and an ultrathin section was prepared in a cross-sectional direction thereof and observed under a transmission type electron microscope.

### <Light transmission factor>

The light shielding colored layer of the back sheet for a solar battery prepared was turned to a light emitting side of a spectrophotometer to measure a light transmission factor (%) thereof in a wavelength of 350 nm.

### <Curling property>

The back sheet for a solar battery prepared was cut to 100 mm square, and the sheet cut was subjected to dry heating- at 150°C for 30 minutes and then left standing and cooled on a flat plate at room temperature. A corner which was the highest in a vertical direction among four corners of the sheet which was concave-wise left standing still was measured for a distance from the flat plate to judge a curling property thereof according to the following criteria.
⊚: height less than 5 mm
O height 5 mm or more and less than 10 mm
×: height 10 mm or more

### <Water vapor transmission rate (WTR) (g/m²/day)>

A glass plate, the ethylene-vinyl acetate copolymer (EVA) sheet ("Solar Ever SC4", manufactured by Mitsui Chemicals Fabro, Inc.) and the back sheet for a solar battery prepared were superposed and subjected to vacuum pressure bonding at 150°c for 15 minutes in a form in which a peeling film was interposed between the EVA sheet and the back sheet in a central part thereof to integrate them. Further, the glass plate/the EVA sheet/the back sheet for a solar battery was heated at 150°c for 30 minutes. After storing them at 85 °c and 85 RH % for 1000 hours and 2000 hours, the back sheet corresponding to an area part of the peeling film was cut out and dried in the air at room temperature for 2 days, and a water vapor transmission rate thereof was measured on the conditions of 40°C and 90 RH % by means of a water vapor transmission rate equipment (Model 17002, manufactured by Illinois instruments Inc.).

### <EVA adhesive property>

A glass plate, the ethylene-vinyl acetate copolymer (EVA) sheet ("Solar Ever SC4", manufactured by Mitsui Chemicals Fabro, Inc.) and the back sheet for a solar battery prepared were superposed and subjected to vacuum pressure bonding at 150°C for 15 minutes to integrate them. Further, after the glass plate/the EVA sheet/the back sheet for a solar battery was heated at 150°C for 30 minutes and stored at 85°C and 85 RH % for 1000 hours and 2000 hours, it was cut out in a width of 15 mm, and an adhesive state thereof with the EVA sheet in 90 degree peeling carried out by an autograph was evaluated on the following criteria.
⊚ : peeling strength: 1000 g/15 mm or more
○: peeling strength: 300 g/15 mm or more and less than 1000 g/15 mm
× : peeling strength: less than 300 g/15 mm

First, a light shielding colored film, a gas barriering film and a weather resistant film were prepared respectively by methods shown below, and then they were laminated to prepare a back sheet for a solar battery.

### <Preparation of light shielding colored polypropylene film>

### (1) Preparation of light shielding colored polypropylene film

In a multilayer (three layers) film extrusion equipment, a mixture of a propylene homopolymer ("Novatec PP-FY6HA" manufactured by Japan Polypropylene Corporation) 40 parts by mass, a propylene random copolymer ("Grand Polypro F327" manufactured by Grand Polymer Co., Ltd.) 60 parts by mass and a hindered amine base light stabilizer (manufactured by Ciba Specialty Chemicals K.K.) 0.1 part by mass was used for both outer layers, and a mixture of the propylene homopolymers ("Novatec PP-FY6HA" manufactured by Japan Polypropylene Corporation) 40 parts by mass, the propylene random copolymer ("Grand Polypro F327" manufactured by Grand Polymer Co., Ltd.) 60 parts by mass, the hindered amine base light stabilizer (manufactured by Ciba Specialty Chemicals K.K.) 0.1 part by mass and titanium oxide 10 parts by mass was used for an inner layer to prepare multilayer polypropylene films in which an inner layer was whitened and which had a three layer thickness ratio of 1 : 3 : 1 and a whole thickness of 50 µm and 100 µm. Then, both surfaces thereof were subjected to corona treatment.

### (2) Preparation of light shielding colored polyethylene film

In a multilayer (three layers) film extrusion equipment, a mixture comprising high density polyethylene ("Novatec HD-HF" manufactured by Japan Polyethylene Corporation) 70 parts by mass, low density polyethylene ("Novatec LD-LF" manufactured by Japan Polyethylene Corporation) 30 parts by mass and the hindered amine base light stabilizer (manufactured by Ciba specialty Chemicals K.K.) 0.1 part by mass was used for both outer layers, and a mixture comprising high density polyethylene ("Novatec HD-HF" manufactured by Japan Polyethylene Corporation) 70 parts by mass, low density polyethylene ("Novatec LD-LF" manufactured by Japan Polyethylene Corporation) 30 parts by mass, the hindered amine base light stabilizer (manufactured by Ciba Specialty Chemicals K.K.) 0.1 part by mass and titanium oxide 10 parts by mass was used for an inner layer to prepare a multilayer polyethylene film in which an inner layer was whitened and which had a three layer thickness ratio of 1 : 3 : 1 and a whole thickness of 50 µm. Then, both surfaces thereof were subjected to corona treatment.

### (3) Preparation of light shielding colored polyester terephthalate film

A polyethylene terephthalate resin ("Novapecs" manufactured by Mitsubishi Chemical Corporation) 100 parts by mass having an oligomer amount of 0.5 % by mass and titanium oxide 10 parts by mass were used to melt and mix them sufficiently evenly in a single layer extruding equipment by a master batch method, and a non-stretched sheet was extruded on a cast roll. Next, the sheet was stretched in a 3.5 times ratio at 95°C in a longitudinal direction and then stretched in a 4.0 times ratio at 135°C in a lateral direction to prepare a biaxially stretched white polyethylene terephthalate film having a thickness of 50 µm. Then, both surfaces thereof were subjected to corona treatment.

### Example 1

### <Preparation of gas barriering film>

A biaxially stretched polyethylene terephthalate film ("H100C12" manufactured by Mitsubishi Plastics, Inc.) having a thickness of 12 µm was used as a substrate film to subject one surface thereof to corona treatment, and a coating liquid prepared by mixing "Placcel 205" manufactured by Daicel Chemical Industries, Ltd. as polycaprolactonediol and "Denacol EX252" manufactured by Nagase Chemtex Corporation as an epoxy resin so that an equivalent proportion of an epoxy group to a hydroxy group was 1 : 2 was coated thereon by a gravure coating method and dried to form a weather resistant coating layer having a thickness of 0.1 µm.
Then, SiO was vaporized by a high frequency heating method under vacuum of 1 × 10⁻⁵ Torr by means of a vacuum vapor deposition equipment to obtain a gas barriering film having a SiOₓ (x = 1.7) thin film having a thickness of 20 nm on the coating layer.

### <weather resistant polyester base resin film>

A polyethylene naphthalate film ("G65F" manufactured by Teijin DuPont Films Japan Ltd.) having a thickness of 50 µm was used to subject one surface thereof to corona treatment

### <Lamination of respective films>

An adhesive 10 g/m² was coated on a corona-treated surface side of the polyethylene naphthalate film described above by a gravure coating method, and it was stuck on a surface of an inorganic thin film side in the gas barriering film and reeled. Then, the adhesive 10 g/m² was coated on one surface of the light shielding colored (white) film described above in the same manner, and it was stuck on a polyethylene terephthalate film surface side of the gas barriering film on which the polyethylene naphthalate film was stuck.
A mixture of "AD-76P1" and "CAT-10L" each manufactured by Toyo-Morton, Ltd. was used as the adhesive in both cases.

### Example 2

A gas barriering film was obtained in the same manner as in Example 1 to prepare a back sheet for a solar battery, except that the coating liquid for the gas barriering film was changed to the following one.

### Coating liquid:

"Placcel 220" manufactured by Daicel Chemical Industries, Ltd. used as polycaprolactonediol and "Sumijul N-3200" manufactured by Sumika Bayer Urethane Co., Ltd. used as an isocyanate resin were mixed so that an equivalent proportion of an isocyanate group to a hydroxy group was 1 : 1 to prepare a coating liquid.

### Example 3

A gas barriering film was obtained in the same manner as in Example 1 to prepare a back sheet for a solar battery, except that the coating liquid for the gas barriering film was changed to the following one.

### Coating liquid:

"Nippollan 982R" manufactured by Nippon Polyurethane Industry Co., Ltd. used as polycarbonatediol and "Coronate L" manufactured by Nippon Polyurethane Industry Co., Ltd. used as an isocyanate resin were mixed so that an equivalent proportion of an isocyanate group to a hydroxy group was 1 : 1 to prepare a coating liquid.

### Example 4

A gas barriering film was obtained in the same manner as in Example 1 to prepare a back sheet for a solar battery, except that the coating liquid for the gas barriering film was changed to the following one.

### Coating liquid:

"Placcel CD CVD210" manufactured by Daicel Chemical Industries, Ltd. used as polycarbonatediol and "Takenate D-170HN" manufactured by Mitsui Chemicals Polyurethane, Inc. used as an isocyanate resin were mixed so that an equivalent proportion of an isocyanate group to a hydroxy group was 1 : 1 to prepare a coating liquid.

### Example 5

A gas barriering film was obtained in the same manner as in Example 1 to prepare a back sheet for a solar battery, except that the coating liquid for the gas barriering film was changed to the following one.

### Coating liquid:

"S-LEC BL-1 (butyral degree: 63 ± 3 mol %)" manufactured by Sekisui Chemical Co., Ltd. used as a polyvinylbutyral resin and an epoxy resin ("Denacol EX252" manufactured by Nagase Chemtex Corporation) used as a cross-linking agent were mixed so that an equivalent proportion of an epoxy group to a hydroxy group was 1 : 1 to prepare a coating liquid.

### Example 6

A gas barriering film was obtained in the same manner as in Example 1 to prepare a back sheet for a solar battery, except that the coating liquid for the gas barriering film was changed to the following one.

### Coating liquid:

A polyvinyl alcohol resin "Poval PVA-117" (saponification degree: 98.0 to 99.0 mol %, polymerization degree: 1700) 250 g manufactured by Kuraray Co., Ltd. was added to 2400 g of ion-exchanged water and dissolved by heating to prepare an aqueous solution, and 18 g of 35 % hydrochloric acid was added to the aqueous solution. Butylaldehyde 140 g was dropwise added thereto while stirring at 15°C to precipitate resin particles. Then, the temperature was elevated up to 50°C while dropwise adding thereto 150 g of 35 % hydrochloric acid under stirring, and the mixture was maintained for 2 hours. Thereafter, the liquid was cooled down and neutralized by sodium hydrogencarbonate, and the resin particles were washed with water and dried to obtain a polyvinylbutyral resin powder (butyral degree: 70 mol %, isotactic triad type residual hydroxyl group amount: 0.1 mol %), followed by dissolving it in a 4 : 6 mixed solvent of ethanol and toluene to prepare a resin solution. Further, the isocyanate resin "Sumijul N-3200" manufactured by Sumika Bayer Urethane Co., Ltd. was used as a cross-linking agent, and the polyvinylbutyral resin solution and the isocyanate resin were mixed so that an equivalent of an isocyanate group to a hydroxy group was 1 : 1 to prepare a coating liquid.

### Example 7

A gas barriering film was obtained in the same manner as in Example 1 to prepare a back sheet for a solar battery, except that the coating liquid for the gas barriering film was changed to the following one.

### Coating liquid:

A polyvinyl alcohol resin "GOHSENOL" (saponification degree: 97.0 to 98.8 mol %, polymerization degree: 2400) 220 g manufactured by Nippon Synthetic Chemical Industry Co., Ltd. was added to 2810 g of ion-exchanged water and dissolved by heating to prepare an aqueous solution, and 645 g of 35 % hydrochloric acid was added to the aqueous solution while stirring at 20°C. Then, 3.6 g of butylaldehyde was added thereto at 10°C while stirring, and after 5 minutes, 143 g of acetaldehyde was dropwise added thereto while stirring to precipitate resin particles. Next, after the liquid was maintained at 60°C for 2 hours, it was cooled down and neutralized by sodium hydrogencarbonate, and the resin particles were washed with water and dried to obtain a polyvinylacetacetal resin powder (acetal degree: 75 mol %), followed by dissolving it in a 4 : 6 mixed solvent of ethanol and toluene to prepare a resin solution. Then, the isocyanate resin "Sumijul N-3200" manufactured by Sumika Bayer Urethane Co., Ltd. was used as a cross-linking agent, and the polyvinylacetacetal resin solution and the isocyanate resin were mixed so that an equivalent of an isocyanate group to a hydroxy group was 1 : 1 to prepare a coating liquid.

### Example 8

A gas barriering film was obtained in the same manner as in Example 1 to prepare a back sheet for a solar battery, except that the coating liquid for the gas barriering film was changed to the following one.

### Coating liquid:

A four neck flask equipped with a stirrer, a thermometer, a cooling device and a nitrogen-introducing tube was charged with 100 parts by mass of ethyl acetate under nitrogen flow and heated up to 80°C. Then, a mixture of a raw material comprising polymerizable monomer components shown in a blend table (Table 1) and 1 part by mass of benzoyl peroxide was dropwise added thereto in 2 hours and maintained at 80°C for 4 hours to obtain a 50 mass % solution of an acryl base copolymer.
Then, an epoxy base copolymer "Denacol EX622" manufactured by Nagase Chemtex Corporation was mixed with the above acryl base resin solution so that an equivalent ratio of an epoxy group to a carboxyl group was 1 : 1 to prepare a coating liquid.

### Examples 9 to 18

Gas barriering films were obtained in the same manner to prepare back sheets for a solar battery, except that in Example 8, raw materials comprising polymerizable monomer components shown in Table 1 were used to prepare acryl base copolymer solutions, and then the isocyanate resin ("Sumijul N-3200" manufactured by Sumika Bayer Urethane Co., Ltd.) was mixed with the above acryl base resin solutions so that an equivalent proportion of an isocyanate group to a hydroxy group was 1 : 1.

### Example 19

A gas barriering film was obtained in the same manner to prepare a back sheet for a solar battery, except that in Example 8, a raw material comprising polymerizable monomer components shown in Table 1 was used to prepare an acryl base copolymer solution.

**Table 1**

| | | | Example | | | | | | | | | | | |
|---|---|---|---|---|---|---|---|---|---|---|---|---|---|---|
| | | | 8 | 9 | 10 | 11 | 12 | 13 | 14 | 15 | 16 | 17 | 18 | 19 |
| Acryl base raw material | Polymerizable UV ray | kind | a-1 | a-2 | a-2 | a-1 | a-1 | | a-1 | | a-1 | a-1 | a-3 | a-2 |
| | stabilizing monomer | mass part | 5.0 | 5.0 | 2.0 | 3.0 | 0.5 | 0.0 | 1.0 | 0.0 | 3.0 | 2.0 | 2.0 | 5.0 |
| | Polymerizable UV ray | kind | | | b-1 | b-2 | | | b-2 | b-2 | b-3 | b-2 | b-3 | b-1 |
| | absorbing monomer | mass part | 0.0 | 0.0 | 4.0 | 1.0 | 0.0 | 0.0 | 0.5 | 30.0 | 50.0 | 35.0 | 20.0 | 10.0 |
| | Cycloalkyl {meth)acrylate | kind | c-1 | c-1 | c-1 | c-1 | c-1 | c-1 | c-1 | c-1 | | c-1 | c-1 | c-1 |
| | | mass part | 40.0 | 30.0 | 30.0 | 40.0 | 30.0 | 30.0 | 30.0 | 30.0 | 0.0 | 30.0 | 50.0 | 30.0 |
| | | kind | | c-2 | c-2 | | | | | | | | | c-2 |
| | | mass part | | 26.0 | 25.0 | | | | | | | | | 25.0 |
| | Polymerizable copolymer unsaturated monomer having hydroxyl group | | | | | | | | | | | | | |
| | | kind | d-1 | d-2 | d-2 | d-2 | d-2 | d-2 | d-2 | d-2 | d-2 | d-2 | d-2 | |
| | | mass part | 10.0 | 18.0 | 18.0 | 5.0 | 10.0 | 10.0 | 2.0 | 10.0 | 10.0 | 5.0 | 5.0 | |
| | Polymerizable unsaturated monomer | kind | e-1 | | | e-1 | e-1 | e-1 | e-1 | e-3 | e-3 | | | |
| | | mass part | 20.0 | | | 20.0 | 20.0 | 20.0 | 26.0 | 30.0 | 32.0 | | | |
| | | kind | e-2 | e-2 | e-2 | e-2 | e-2 | e-2 | e-2 | | e-4 | e-2 | e-2 | e-2 |
| | | mass part | 24.0 | 20.0 | 20.0 | 30.5 | 39.0 | 39.5 | 40.0 | | 5.0 | 28.0 | 23.0 | 29.0 |
| | | kind | e-6 | e-6 | e-6 | e-6 | e-6 | e-6 | e-6 | | | | | e-6 |
| | | mass part | 1.0 | 1.0 | 1.0 | 0.5 | 0.5 | 0.5 | 0.5 | 0.0 | 0.0 | 0.0 | 0.0 | 1.0 |
| Cross-linking compound | | | A | B | B | B | B | B | B | B | B | B | B | |

| | | | | | | | | | | | | | | |
|---|---|---|---|---|---|---|---|---|---|---|---|---|---|---|
| A: epoxy B: isocyanate | | | | | | | | | | | | | | |

The following monomers were used in the examples described above. Polymerizable UV ray stabilizing monomers:
- a-1:: 4-methacryloyloxy-2,2,6,6-tetramethylpiperidine
- a-2:: 4-methacryloyloxy-2,2,6,6-pentamethylpiperidine
- a-3:: 1-methacryloyl-4-methacryloylamino-2,2,6,6- tetramethylpiperidine
Polymerizable UV ray absorbing monomers:
- b-1:: 2-hydroxy-4-(3-methacryloyloxy-2-hydroxypropoxy)- benzophenone
- b-2:: 2-[2'-hydroxy-5'-(methacryloyloxyethyl)Phenyl]-2H- benzotriazole
- b-3:: 2-[2'-hydroxy-5'-(β-methaeryloyloxyethoxy)-3'-t- butylphenyl]-4-t-butyl-2H-benzotriazole
Cycloalkyl (meth)acrylates:
- c-1:: cyclohexyl methacrylate
- c-2:: t-butylcyclohexyl methacrylate
Polymerizable unsaturated monomers having a hydroxyl group:
- d-1:: hydroxypropyl acrylate
- d-2;: hydroxyethyl methacrylate

Other polymerizable unsaturated monomers:
- e-1:: n-butyl methacrylate
- e-2:: n-butyl acrylate
- e-3:: 2-ethylhexyl acrylate
- e-4:: methyl methacrylate
- e-5:: ethyl acrylate
- e-6:: methacrylic acid
- e-7:: itaconic acid
- e-8:: p-toluenesulfonic acid

### Example 20

A back sheet for a solar battery was prepared in the same manner as in Example 10, except that in the gas barriering film prepared in Example 10, used were three inorganic thin film layer obtained by applying 1 kw under vacuum of 8 × 10⁻² Torr with a 13.56 MHz high frequency discharge plasma source using tetraethoxysilane as a raw material and oxygen, nitrogen and argon as reaction gases by means of a plasma CVD equipment to form a plasma CVD film having a film thickness of 20 nm comprising SiOₓN_{y} (x = 1.6, y = 0.2) on a surfaces of the inorganic thin film and further forming a vacuum vapor deposition film on a surface of the above plasma CVD film by the same method as in Example 1.

### Example 21

A back sheet for a solar battery was prepared in the same manner, except that in Example 10, three gas barriering films were stuck and laminated respectively on an inorganic thin film side and a plastic film side, and then it was laminated on the polyethylene naphthalate film used in Example 1.

### Example 22

A back sheet for a solar battery was prepared in the same manner, except that in Example 6, a biaxially stretched polyethylene naphthalate film ("Q51C12" manufactured by Teijin DuPont Films Japan Ltd.) having a thickness of 12 µm was used as the base material film for the gas barriering film to form a weather resistant coating layer on a corona-treated surface thereof.

### Example 23

A back sheet for a solar battery was prepared in the same manner, except that in Example 10, a coextruded biaxially stretched film of a polyethylene naphthhalate resin and a polyethylene terephthalate resin which was obtained by the following method was used as the base material, film for the gas barriering film to form a weather resistant coating layer on a corona-treated surface thereof.
A reactor was charged with 100 parts of dimethyl naphthalene-2,6-dicarboxylate, 60 parts of ethylene glycol and 0.1 part of magnesium acetate tetrahydrate and heated from a reaction initiating temperature of 180°C up to 230°C in 4 hours to subject them to transesterification, and 0.2 part of amorphous silica having an average particle diameter of 2.5 µm was added thereto in the form of a slurry of ethylene glycol. Next, 0.04 part of phosphoric acid and 0.04 part of antimony trioxide were added thereto, and then polycondensation reaction was carried out by an ordinary method. Thus, polyethylene naphthalate having an intrinsic viscosity of 0.58 was obtained. The above product was chipped and subjected to solid phase polymerisation at 235°C under reduced pressure to obtain a polyethylene naphthalate resin having an intrinsic viscosity of 0.68.
Next, the polyethylene naphthalate resin described above and a polyethylene terephthalate resin (Novapecs, manufactured by Mitsubishi Chemical Corporation) were extruded on a cast roll by a coextrusion method to obtain a formless sheet. Subsequently, it was stretched in a ratio in a 3.0 times ratio in a longitudinal direction and then in a 3.5 times ratio in a lateral direction and thermally fixed to prepare a coextruted biaxially stretched film having a thickness ratio polyethylene naphthalate : polyethylene terephthalate of 1 : 3 and a total thickness of 12 µm, and a polyethylene naphthalate surface side thereof was subjected to corona treatment.

### Example 24

A back sheet for a solar battery was prepared in the same manner, except that in Example 10, the coextruded biaxially stretched polyethylene naphthalate film ("Q51C12" manufactured by Teijin DuPont Films Japan Ltd.) having a thickness of 12 µm was used as the base material film for the gas barriering film to form a weather resistant coating layer on a corona-treated surface, whereby a gas barriering film was obtained, and a biaxially stretched film having a thickness of 50 µ m which comprised a polyethylene terephthalate resin having a number average molecular weight of 25,000 and had a heat shrinkage rate of 0.9 % on the conditions of 150°C and 30 minutes was used for the weather resistant polyester base resin layer.

### Example 25

A back sheet for a solar battery was obtained in the same manner, except that in Example 10, the biaxially stretched polyethylene naphthalate film ("Q51C12" manufactured by Teijin DuPont Films Japan Ltd.) having a thickness of 12 µm was used as the base material film for the gas barriering film.

### Example 26

A back sheet for a solar battery was obtained in the same manner, except that in Example 25, the light shielding colored film was changed to (2) the light shielding colored polyethylene film in <preparation of light shielding colored film> described above.

### Example 27

A back sheet for a solar battery was obtained in the same manner, except that in Example 25, a thickness of the light shielding colored film was raised to 100 µm.

### Example 28

A back sheet for a solar battery was obtained in the same manner, except that in Example 27, a biaxially stretched transparent polyethylene terephthalate film ("T100" manufactured by Mitsubishi Plastics, Inc.) having a thickness of 50 µm was provided as an intermediate layer between the light shielding colored film and the gas barriering film.

### Example 29

A biaxially stretched polyethylene naphthalate film ("Q65F100" manufactured by Teijin DuPont Films Japan Ltd.) having a thickness of 100 µm was used as a base material film for a gas barriering film and subjected to corona treatment, and a weather resistant coating layer was formed on the above corona-treated surface to obtain a gas barriering film in the same manner as in Example 6, whereby a film comprising the gas barriering layer containing the weather resistant coating layer and the inorganic thin film layer and the weather resistant polyester base resin layer was prepared. Then, the light shielding colored (white) film prepared in Example 1 in which 10 g/m² of the adhesive was coated on one surface thereof was stuck on an inorganic thin film surface side of the above gas barriering layer and laminated to prepare a back sheet for a solar battery.

### Example 30

A back sheet for a solar battery was obtained in the same manner, except that in Example 27, the biaxially stretched transparent polyethylene terephthalate film ("T100" manufactured by Mitsubishi Plastics, Inc.) having a thickness of 50 µm was provided as an intermediate layer between the light shielding colored film and the gas barriering film.

### Example 31

A back sheet for a solar battery was obtained in the same manner, except that in Example 30, a thickness of the light shielding colored film was raised to 100 µm.

### Example 32

A back sheet for a solar battery was prepared in the same manner as in Example 6, except that barium sulfate was used as a white pigment for the light shielding colored film.

### Example 33

A back sheet for a solar battery was prepared in the same manner as in Example 21, except that in the light shielding colored film prepared in Example 1, carbon black ("#650B" manufactured by Mitsubishi Chemical Corporation) was used in place of the white pigment (titanium oxide) to prepare a light shielding colored film containing 5 % by mass of carbon black in an inner layer.

### Example 34

A film comprising a gas barriering layer and a weather resistant polyester base resin layer was prepared in the same manner, except that in Example 29, the coating liquid prepared in Example 10 was used for the weather resistant coating layer. Then, the light shielding colored film prepared in Example 33 in which 10 g/m² of the adhesive was coated was stuck on an inorganic thin film surface of the above gas barriering film and laminated to prepare a back sheet for a solar battery.

### Example 35

A back sheet for a solar battery was obtained in the same manner, except that in Example 34, the biaxially stretched transparent polyethylene terephthalate film ("T100" manufactured by Mitsubishi Plastics, Inc.) having a thickness of 50 µm was provided as an intermediate layer between the light shielding colored film and the gas barriering film.

### Comparative Example 1

A gas barriering film was obtained in the same manner as in Example 1 to prepare a back sheet for a solar battery, except that the weather resistant coating layer was not formed on the gas barriering film.

### Comparative Example 2

A gas barriering film was obtained in the same manner as in Example 1 to prepare a back sheet for a solar battery, except that the coating liquid for the gas barriering film was changed to the following one.

### Coating liquid:

Saturated polyester ("VYLON 300" manufactured by Toyobo Co., Ltd.) and an isocyanate compound ("Coronate L" manufactured by Nippon Polyurethane Industry Co., Ltd.) were mixed in a mass ratio of 1 : 1 to prepare a coating liquid.

### Comparative Example 3

A gas barriering film was obtained in the same manner as in Example 1 to prepare a back sheet for a solar battery, except that the coating liquid for the gas barriering film was changed to the following one.

### Coating liquid:

An acryl base copolymer ("Takelac UA-902" manufactured by Mitsui Chemicals Polyurethane, Inc.) and aromatic isocyanate (tolylenediisocyanate (TDI), "Cosmonate 80" manufactured by Mitsui Chemicals Polyurethane, Inc.) were mixed so that an equivalent proportion of an isocyanate group value to a hydroxy group value was 1 : 1 to prepare a coating liquid.

### Comparative Example 4

A gas barriering film was obtained in the same manner to prepare a back sheet for a solar battery, except that in Comparative Example 1, the light shielding colored film was changed to (3) the light shielding colored polyethylene terephthalate film in <preparation of light shielding colored film> described above.

### Comparative Example 5

A gas barriering film was obtained in the same manner to prepare a back sheet for a solar battery, except that in Example 10, a polypropylene film having a thickness of 50 µm which was prepared in a single layer extruding equipment using a mixture of a propylene homopolymer ("Navatec PP-FY6HA" manufactured by Japan Polypropylene Corporation) 40 parts by mass, a propylene random copolymer ("Grand Polypro F327" manufactured by Grand Polymer Co., Ltd.) 60 parts by mass and a hindered amine base light stabilizer (manufactured by Ciba Specialty Chemicals K.K.) 0.1 part by mass and which was subjected to corona treatment on one surface thereof was used in place of the weather resistant polyester base resin film.
When a glass plate, an ethylene-vinyl acetate copolymers (EVA) and the back sheet for a solar battery prepared were superposed and subjected to vacuum pressure bonding at 150°C for 15 minutes to integrate them, the polypropylene film of an outermost layer was deformed, and pressure bonded surface traces of the vacuum laminator were transferred, so that the appearance was notably damaged.

The respective back sheets obtained in the examples and the comparative examples described above were evaluated for a light transmission factor in a wavelength of 350 nm, a water vapor transmission rate (WTR) after stored at 85°C and 85 % RH for 1000 hours and 2000 hours and an EVA adhesive property, and the results thereof are shown in Table 2.

**Table 2-1**

| | Light shielding colored film | | | Intermediate layer | Gas barriering film | | | | | Weather resistant base resin film | |
|---|---|---|---|---|---|---|---|---|---|---|---|
| | Substrate film | pigment | ThickNess (µm) | | Substrate film | ThickNess (µm) | Weather resistant coat | Inorganic thin film | Laminate | Substrate film | Thickness (µm) |
| Example 1 | PP | Titanium oxide | 50 | None | PET | 12 | Polycaprolactone-diol + epoxy | SiOx | 1 film | PEN | 50 |
| Example 2 | PP | Titanium oxide | 50 | None | PET | 12 | Polycaprolactone-polyol + isocyanate | SiOx | 1 film | PEN | 50 |
| Example 3 | PP | Titanium oxide | 50 | None | PET | 12 | Polycarbonate-diol + isocyanate | SiOx | 1 film | PEN | 50 |
| Example 4 | PP | Titanium oxide | 50 | None | PET | 12 | Polycarbonate-diol + isocyanate | SiOx | 1 film | PEN | 50 |
| Example 5 | PP | Titanium oxide | 50 | None | PET | 12 | Polyvinylbutyral +epoxy | SiOx | 1 film | PEN | 50 |
| Example 6 | PP | Titanium oxide 50 | 50 | None | PET | 12 | Polyvinylbutyral + isocyanate | SiOx | 1 film | PEN | 50 |
| Example 7 | PP | Titanium oxide | 50 | None | PET | 12 | Polyacetacetal + isocyanare | SiOx | 1 film | PEN | 50 |
| Example 8 | PP | Titanium oxide | 50 | None | PET | 12 | Acryl copolymer + epoxy | SiOx | 1 film | PEN | 50 |
| Example 9 | PP | Titanium oxide | 50 | None | PET | 12 | Acryl copolymer + isocyanate | SiOx | 1 film | PEN | 50 |
| Example 10 | PP | Titanium oxide | 50 | None | PET | 12 | Acryl copolymer + isocyanate | SiOx | 1 film | PEN | 50 |
| Example 11 | PP | Titanium oxide | 50 | None | PET | 12 | Acryl Copolymer + isocyanate | SiOx | 1 film | PEN | 50 |
| Example 12 | PP | Titanium | | None | PET | 12 | Acryl copolymer + isocyanate | SiOx | 1 film | PEN | 50 |
| Example 13 | PP | Titanium oxide | 50 | None | PET | 12 | Acryl copolymer + isocyanate | SiOx | 1 film | PEN | 50 |
| Example 14 | PP | Titanium oxide | 50 | None | PET | 12 | Acryl copolymer Acryl copolymer + isocyanate | SiOx | 1 film | PEN | 50 |
| Example 15 | PP | Titanium oxide | 50 | None | PET | 12 | Acryl copolymer Acryl copolymer +isocyanate | SiOx | 1 film | PEN | 50 |
| Example 16 | PP | Titanium oxide | 50 | None | PET | 12 | Acryl Copolymer + isocyanate | SiOx | 1 film | PEN | 50 |
| Example 17 | PP | Titanium oxide | 50 | None | PET | 12 | Acryl copolymer + isocyanate | SiOx | 1 film | PEN | 50 |
| Example 18 | PP | Titanium oxide | 50 | None | PET | 12 | Acryl copolymer + isocyanate | SiOx | 1 film | PEN | 50 |

**Table 2-2**

| | Light shielding colored film | | | Intermediate layer | Gas barriering film | | | | | Weather resistant polyester base resin film | |
|---|---|---|---|---|---|---|---|---|---|---|---|
| | Substrate film | Pigment | Thickness [µm] | | Substrate film | Thickness (µm) | Weather resistant coat | Inorganic thin film | Laminate | Substrate film | Thickness [µm] |
| Example 19 | Titanium PP | Titanium oxide | 50 | None | PET | 12 | Acryl copolymer | SiOx | 1 film | PEN | 50 |
| Example 20 | PP | Titanium oxide | 50 | None | PET | 12 | Acryl copolymer + isocyanate | SiOx/SiONy/SiOx | 1 film | PEN | 50 |
| Example 21 | PP | Titanium oxide | 50 | None | PET | 12 | Acryl copolymer + isocyanate | SiOx | 3 film | PEN | 50 |
| Example 22 | PP | Titanium oxide | 50 | None. | PEN | 12 | Polyvinylbutyral + isocyanate | SiOx | 1 film | PEN | 50 |
| Example 23 | PP | Titanium oxide | 50 | None | PEN/ PET | 12 | Acryl copolymer + isocyanate | SiOx | 1 film | PEN | 50 |
| Example 24 | PP | Titanium oxide | 50 | None | PEN | 12 | Acryl copolymer + isocyanate | SiOx | 1 film | PET | 50 |
| Example 25 | PP | Titanium oxide | 50 | None | PEn | 12 | Acryl copolymer + isocyanate | SiOx | 1 film | PEN | 50 |
| Example 26 | PE | Titanium oxide | 50 | None | PEN | 12 | Acryl copolymer + isocyanate | SiOx | 1 film | PEN | 50 |
| Example 27 | PP | Titanium oxide | 100 | None | PEN | 12 | Acryl copolymer + isocyanate | SiOx | 1 film | PEN | 50 |
| Example 28 | PP | Titanium oxide | 100 | PET 50µm | PEN | 12 | Acryl copolymer + isocyanate | SiOx | 1 film | PEN | 50 |
| example 29 | PP | Titanium oxide | 50 | None | double with weather resistant film | | Polyvinylbutyral + isocyanate | SiOx | 1 film | PEN | 100 |
| Example 30 | PP | Titanium oxide | 50 | PET 50µm | double with weather resistant film | | Polyvinylbutyral + isocyanate | SiOx | 1 film | PEN | 100 |
| Example 31 | PP | Titanium oxide | 100 | PET 50µm | double with weather resistant film | | Polyvinylbutyral + isocyanate | SiOx | 1 film | PEN | 100 |
| Example 32 | PP | Barium sulfate | 50 | None | PET | 12 | Polyvinylbutyral + isocyanate | SiOx | 1 film | PEN | 50 |
| Example 33 | PP | Carbon black | 50 | None | PET | 12 | Acryl copolymer + isocyanate | SiOx | 3 films | PEN | 50 |
| Example 34 | PP | Carbon black | 50 | None | double with weather resistant film | | Acryl copolymer + isocyanate | SiOx | 1 film | PEN | 100 |
| Example 35 | PP | Carbon black | 50 | PET 50µm | double with weather resistant film | | Acryl copolymer + isocyanate | SiOx | 1 film | PEN | 100 |
| Comparative Example 1 | PP | Titanium oxide | 50 | None | PET | 12 | None | SiOx | 1 film | PEN | 50 |
| Comparative Example 2 | PP | Titanium oxide | 50 | None | PET | 12 | Polyesterpolyol + isocyanate | SiOx | 1 film | PEN | 50 |
| Comparative Example 3 | PP | Titanium oxide | 50 | None | PET | 12 | Acrylpolyol + isocyanate | SiOx | 1 film | PEN | 50 |
| Comparative Example 4 | PET | Titanium oxide | 50 | None | PEN | 12 | None | SiOx | 1 film | PEN | 50 |
| Comparative Example 5 | PP | Titanium oxide | 50 | None | PEN | 12 | Acryl copolymer + isocyanate | SiOx | 1 film | PP | 50 |

**Table 2-3**

| | Back sheet | Back sheet 150°C, 30 minutes | Back sheet after 85°C, 85 RH %, 1000 hours | | Back sheet after 85°C, 85 RH %, 2000 hours | |
|---|---|---|---|---|---|---|
| | Light transmission factor (%) | Curling property | WTR (g/m²day) | EVA adhesive property | WTR (g/m²/day) | EVA adhesive property |
| Example 1 | <0.1 | ⊚ | 0.6 | ⊚ | 0.9 | ⊚ |
| Example 2 | <0.1 | ⊚ | 0.6 | ⊚ | 0.9 | ⊚ |
| Example 3 | <0.1 | ⊚ | 0.6 | ⊚ | 0.9 | ⊚ |
| Example 4 | <0.1 | ⊚ | 0.6 | ⊚ | 0.9 | ⊚ |
| Example 5 | <:0.1 | ⊚ | 0.5 | ⊚ | 0.7 | ⊚ |
| Example 6 | <:0.1 | ⊚ | 0.5 | ⊚ | 0.7 | ⊚ |
| Example 7 | <:0.1 | ⊚ | 0.5 | ⊚ | 0.7 | ⊚ |
| Example 8 | <0.1 | ⊚ | 0.5 | ⊚ | 0.7 | ⊚ |
| Example 9 | <0.1 | ⊚ | 0.3 | ⊚ | 0.5 | ⊚ |
| Example 10 | <0.1 | ⊚ | 0.3 | ⊚ | 0.5 | ⊚ |
| Example 11 | <0.1 | ⊚ | 0.3 | ⊚ | 0.5 | ⊚ |
| Example 12 | <0.1 | ⊚ | 0.3 | ⊚ | 0.5 | ⊚ |
| Example 13 | <0.1 | ⊚ | 0.3 | ⊚ | 0.5 | ⊚ |
| Example 14 | <0.1 | ⊚ | 0.3 | ⊚ | 0.5 | ⊚ |
| Example 15 | <0.1 | ⊚ | 0.3 | ⊚ | 0.5 | ⊚ |
| Example 16 | <0.1 | ⊚ | 0.3 | ⊚ | 0.5 | ⊚ |
| Example 17 | <0.1 | ⊚ | 0.3 | ⊚ | 0.5 | ⊚ |
| Example 18 | <:0.1 | ⊚ | 0.3 | ⊚ | 0.5 | ⊚ |

**Table 2-4**

| | Back sheet | Back sheet 150°C, 30 minutes | Back sheet after 85°C, 85 RH %, 1000 hours | | Back sheet after 85°C, 85 RH %, 2000 hours | |
|---|---|---|---|---|---|---|
| | Light transmission factor (%) | Curling property | WTR (g/m²/day) | EVA adhesive property | WTR (g/m²/day) | EVA adhesive property |
| Example 19 | <0.1 | ⊚ | 0.6 | ⊚ | 0.9 | ⊚ |
| Example 20 | <0.1 | ⊚ | 0.2 | ⊚ | 0.3 | ⊚ |
| example 21 | <0.1 | ⊚ | <:0.1 | ⊚ | <0.1 | ⊚ |
| Example 22 | <0.1 | ⊚ | 0.2 | ⊚ | 0.3 | ⊚ |
| Example 23 | <0.1 | ⊚ | 0.2 | ⊚ | 0.3 | ⊚ |
| Example 24 | <0.1 | ⊚ | 0.4 | ⊚ | 0.6 | ⊚ |
| Example 25 | <0.1 | ⊚ | <0.1 | ⊚ | <0.1 | ⊚ |
| Example 26 | <0.1 | ○ | <0.1 | ⊚ | <0.1 | ⊚ |
| Example 27 | <0.1 | ⊚ | <0.1 | ⊚ | <0.1 | ⊚ |
| Example 28 | <0.1 | ⊚ | <0.1 | ⊚ | <0.1 | ⊚ |
| Example 29 | <:0.1 | ⊚ | 0.2 | ⊚ | 0.3 | ⊚ |
| Example 30 | <0.1 | ⊚ | 0.2 | ⊚ | 0.3 | ⊚ |
| Example 31 | <0.1 | ⊚ | 0.2 | ⊚ | 0.3 | ⊚ |
| Example 32 | 0.1 | ⊚ | 0.5 | ⊚ | 0.7 | ⊚ |
| Example 33 | <0.1 | ⊚ | <0.1 | ⊚ | <0.1 | ⊚ |
| Example 34 | <0.1 | ⊚ | <0.1 | ⊚ | 0.1 | ⊚ |
| Example 35 | <0.1 | ⊚ | <0.1 | ⊚ | <0.1 | ⊚ |
| Comparative Example 1 | <0.1 | ⊚ | >50 | ⊚ | >50 | ⊚ |
| Comparative Example 2 | <0.1 | ⊚ | >50 | ⊚ | >50 | ⊚ |
| Comparative Example 3 | <0.1 | ⊚ | >10 | ⊚ | >50 | ⊚ |
| Comparative Example 4 | <0.1 | ⊚ | >50 | ○ | >50 | × |
| Comparative Example 5 | <0.1 | × | 0.5 | ⊚ | 0.7 | ⊚ |

### INDUSTRIAL APPLICABILITY

The back sheet for a solar battery according to the present invention is excellent in a gas barriering property, a weatherability, a light shielding property and an adhesive property with a filler in use for long time, and therefore it can suitably be used as a back sheet corresponding to various modules for solar batteries of a monocrystalline silicon base, an amorphous silicon base, a thin film crystal base, a compound semiconductor base, an organic thin film base, a dye sensitizing base and the like.

## Claims

1. A back sheet for a solar battery comprising a light shielding polyolefin base resin colored layer and a weather resistant polyester base resin layer and comprising a gas barriering layer containing a weather resistant coating layer and an inorganic thin film layer provided between the above layers, wherein the weather resistant coating layer comprises at least one selected from (a) a cross-linked product of polycaprolactonepolyol and/or polycarbonatepolyol, (b) a cross-linked product of modified polyvinyl alcohol and (c) an acryl base copolymer having at least one group selected from the group consisting of a UV ray stabilizing group, a UV ray absorbing group and a cycloalkyl group.

2. The back sheet for a solar battery according to claim 1, wherein the cross-linked product (a) of polycaprolactonepolyol and/or polycarbonatepolyol is obtained by cross-linking polycaprolactonepolyol and/or polycarbonatepolyol with an isocyanate compound and/or an epoxy compound.

3. The back sheet for a solar battery according to claim 1 or 2, wherein the modified polyvinyl alcohol of (b) is polyvinylbutyral and/or polyvinylacetal.

4. The back sheet for a solar battery according to any of claims 1 to 3, wherein the acryl base copolymer (c) having at least one group selected from the group consisting of a UV ray stabilizing group, a UV ray absorbing group and a cycloalkyl group is obtained by reacting an acryl base copolymer having at least one groups selected from the group consisting of a hindered amine group, a benzotriazole group and/or a benzophenone group and a cycloalkyl group and a hydroxyl group with an isocyanate compound and/or an epoxy compound.

5. The back sheet for a solar battery according to any of claims 1 to 4, comprising two or more gas barriering layers containing a weather resistant coating layer and an inorganic thin film layer.

6. The back sheet for a solar battery according to any of claims 1 to 5, wherein the light shielding polyolefin base resin colored layer comprises a white film or a black films.

7. The back sheet for a solar battery according to any of claims 1 to 6, wherein the light shielding polyolefin base resin colored layer has a light transmission factor of 1.0 % or less in a wavelength of 350 nm.

8. The back sheet for a solar battery according to any of claims 1 to 7, wherein the light shielding polyolefin base resin colored layer is prepared by providing a transparent polyolefin base resin layer at least on an outside surface of a colored layer containing a pigment.

9. The back sheet for a solar battery according to any of claims 1 to 8, wherein the light shielding polyolefin base resin colored layer comprises a transparent polyolefin resin layer/a polyolefin base resin layer containing a pigment selected from titanium oxide, barium sulfate and carbon black/a transparent polyolefin base resin layer.

10. The back sheet for a solar battery according to any of claims 1 to 9, wherein the gas barriering layer contains a polyester base resin.

11. The back sheet for a solar battery according to any of claims 1 to 10, wherein the gas barriering layer contains a polyethylene naphthalate resin.

12. The back sheet for a solar battery according to any of claims 1 to 11, wherein the weather resistant polyester base resin layer has a strength holding rate of 50 % or more after 3000 hours at 85°C and 85 RH %.

13. The back sheet for a solar battery according to any of claims 1 to 12, wherein other film are further provided between any layers of the light shielding polyolefin base resin colored layer, the gas barriering layer and the weather resistant polyester base resin layer.

14. The back sheet for a solar battery according to claim 13, wherein the other films comprise a polyester base resin film.

15. The back sheet for a solar battery according to any of claims 1 to 14, comprising a film comprising the light shielding polyolefin base resin colored layer and a film comprising the weather resistant polyester base resin layer and comprising a film comprising the gas barriering layer containing the weather resistant coating layer and the inorganic thin film layer provided between the above films.

16. The back sheet for a solar battery according to any of claims 1 to 14, comprising (1) a film comprising the light shielding polyolefin base resin colored layer and the gas barriering layer containing the weather resistant coating layer and the inorganic thin film layer and (2) a film comprising the weather resistant polyester base resin layer.

17. The back sheet for a solar battery according to any of claims 1 to 14, comprising (1) a film comprising the light shielding polyolefin base resin colored layer and (2) a film comprising the gas barriering layer containing the weather resistant coating layer and the inorganic thin film layer and the weather resistant polyester base resin layer.

18. A solar battery module comprising the back sheet for a solar battery according to any of claims 1 to 17.
